# EUROPEAN PATENT APPLICATION

(11) **EP 4 293 562 A1**
(43) Date of publication of application: **20.12.2023**
(21) Application number: 23161608.7
(22) Date of filing: 13.03.2023
(51) Int. Cl.: G06F 30/13

(54) **AUTOMATED TOOLS FOR ASSESSING BUILDING MAPPING INFORMATION GENERATION**

(30) Priority: 16.06.2022 US 202217842419
(71) Applicant: MFTB Holdco, Inc., Seattle, Washington 98101 (US)
(72) Inventor: Narayana, Manjunath, Chino Hills (US); Buehler, Christopher, Seattle (US); Boyadzhiev, Ivaylo, Seattle (US)
(74) Representative: Loveless, Ian Mark

(57) **Abstract**

Techniques are described for computing devices to perform automated operations related to using images acquired in a building as part of an automated generation process of a floor plan or other mapping information for the building, in some cases without using depth information from depth-sensing equipment about distances from the images' acquisition locations to objects in the surrounding building, and for subsequent use in further automated manners, such as controlling navigation of mobile devices and/or for display to end users in a corresponding graphical user interface. The analysis and assessment of the building images may, for example, include performing an automated assessment of one or more characteristics of the mapping information generation process (*e.g.,* a predicted amount of time for completion) and to provide automated instructions (*e.g.,* to adjust image acquisition device settings) or other feedback to improve the generation process (*e.g.,* reduce that predicted time).

## Description

### TECHNICAL FIELD

The following disclosure relates generally to using automated tools and associated techniques to analyze, assess and use images acquired in a defined area as part of generating mapping information for the area, such as to automatically generate a floor plan for a building using images acquired at the building and to assess characteristics of the automated generation process, as well as subsequently using the generated mapping information.

### BACKGROUND

In various fields and circumstances, such as architectural analysis, property inspection, real estate acquisition and development, remodeling and improvement services, general contracting and other circumstances, it may be desirable to view information about the interior of a house, office, or other building without having to physically travel to and enter the building, including to determine actual as-built information about the building rather than design information from before the building is constructed. However, it can be difficult to effectively capture, represent and use such building interior information, including to display visual information captured within building interiors to users at remote locations (*e.g*., to enable a user to fully understand the layout and other details of the interior, including to control the display in a user-selected manner). In addition, while a floor plan of a building may provide some information about layout and other details of a building interior, such use of floor plans has some drawbacks in certain situations, including that floor plans can be difficult to construct and maintain, to accurately scale and populate with information about room interiors, to visualize and otherwise use, etc.

### BRIEF DESCRIPTION OF THE DRAWINGS

Figures 1A-1B are diagrams depicting an exemplary building environment and computing system(s) for use in embodiments of the present disclosure, including to generate and present information representing the building.
Figures 2A-2N illustrate examples of automated operations involved in acquisition, analysis, assessment and use of images for a building, such as for resulting generation of a floor plan for the building.
Figure 3 is a block diagram illustrating computing systems suitable for executing embodiments of one or more systems that perform at least some of the techniques described in the present disclosure.
Figure 4 illustrates an example embodiment of a flow diagram for an Automated Building Information Assessment (ABIA) system routine in accordance with an embodiment of the present disclosure.
Figures 5A-5B illustrate an example embodiment of a flow diagram for a Mapping Information Generation Manager (MIGM) system routine in accordance with an embodiment of the present disclosure.
Figure 6 illustrates an example embodiment of a flow diagram for an Image Capture and Analysis (ICA) system routine in accordance with an embodiment of the present disclosure.
Figure 7 illustrates an example flow diagram for a Building Information Access system routine in accordance with an embodiment of the present disclosure.

### DETAILED DESCRIPTION

The present disclosure describes techniques for using one or more computing devices to perform automated operations related to, as part of generating mapping information of a defined area for subsequent use in one or more further automated manners, performing analyses, assessments and/or other uses of images acquired in the defined area. In at least some embodiments, the defined area includes an interior of a multi-room building (e.g., a house, office, etc.), the images include panorama images acquired at the building (*e.g*., 360° panorama images acquired at various acquisition locations within rooms of the building), and the generated information includes a floor plan of the building, such as a 2D (two-dimensional) overhead view (e.g., an orthographic top view) of a schematic floor map that is generated using information from the images - in at least some such embodiments, the generating of the mapping information is further performed without having or using depth information acquired from depth-sensing equipment about distances from the images' acquisition locations to walls or other objects in the surrounding building interior. The analysis and assessment of the building images may include performing an automated assessment of characteristics of the automated mapping information generation process, such as to assess, for example, a predicted amount of time for the automated generation process to complete and to provide automated instructions (*e.g.*, to adjust image acquisition device settings or parameters) or other feedback to reduce that amount of time or otherwise improve the generation process. The generated floor plan and/or other generated mapping-related information may be subsequently used in one or more manners in various embodiments, such as for controlling navigation of mobile devices (*e.g*., autonomous vehicles), for display on one or more client devices in corresponding GUIs (graphical user interfaces), etc. Additional details are included below regarding the automated operations of the computing device(s) involved in the generation and use of the mapping information, and some or all of the techniques described herein may, in at least some embodiments, be performed at least in part via automated operations of an Automated Building Information Assessment ("ABIA") system involved in the analysis and assessment of the building images, as discussed further below.

In at least some embodiments and situations, some or all of the images acquired for a building are 360° panorama images that are each acquired at one of multiple acquisition locations in or around the building, such as with each panorama image covering 360 degrees horizontally around a vertical axis (*e.g.*, by using an image acquisition device with a camera having one or more fisheye lenses to capture a panorama image that extends 360 degrees horizontally, such as in a single moment, or by otherwise generating 360° panorama images, such as by horizontally rotating a camera at an acquisition location that captures video or a sequence of constituent images during the rotating). In addition, in at least some such embodiments, such panorama images may be provided and used in a spherical format having an equirectangular projection in which straight vertical data (*e.g.*, the sides of a typical rectangular door frame) in the room remains straight in the image and in which straight horizontal data (*e.g.*, the top of a typical rectangular door frame) in the room remains straight in the image if it is shown at a horizontal midline of the image but is increasingly curved in the image in a convex manner relative to the horizontal midline as the distance increases in the image from the horizontal midline. It will be appreciated that a 360° panorama image may in some situations be represented in a spherical format and cover up to 360° around a vertical axis, such that a user viewing such a panorama image may move the viewing direction within the panorama image to different orientations to cause different subset images (or "views") to be rendered within the panorama image (including, if the panorama image is represented in a spherical format, to convert the image being rendered into a planar coordinate system, such as for a perspective image view before it is displayed). Furthermore, acquisition metadata regarding the capture of such panorama images and/or other images (*e.g.*, photos and other perspective images with an angle of view less than 180° and in a rectilinear format in which horizontal and vertical straight lines in the room remain straight in the perspective images) may be obtained and used in various manners, such as data acquired from IMU (inertial measurement unit) sensors or other sensors of a mobile image acquisition device as it is carried by a user or otherwise moved (including to assist in a determining an acquisition 'pose' for an image that includes at acquisition location at which the image was captured and an orientation or direction associated with the image, such as a direction of the camera lens for a non-panoramic photo image, a starting and/or ending direction for a panoramic image, etc.), and/or other data from other associated sensors (*e.g*., depth data from one or more depth sensors or other distance-measuring devices at an image acquisition location to measure distances to walls of the room or other objects in the room surrounding the acquisition location). Additional details are included below regarding automated operations of device(s) implementing an Image Capture and Analysis (ICA) system involved in acquiring images and optionally acquisition metadata, as well as in optionally performing preprocessing of the images before later use (*e.g.*, to render 360° panorama images in an equirectangular format).

The automated operations of the computing device(s) to provide the described techniques may in some embodiments and situations further include automated operations of a Mapping Information Generation Manager (MIGM) system to implement an automated generation process that produces a floor plan and/or other mapping information for a building based at least in part on the visual data of images (*e.g*., 360° panorama images) acquired at multiple acquisition locations in and optionally around the building. In at least some such embodiments, the automated operations of the MIGM system may include assessing images and/or their associated acquisition metadata (*e.g*., images and/or metadata provided in part or in whole by the ICA system) in order to generate information about room shapes and layouts of rooms of a building for use during generation of a floor plan of the building, whether during the acquisition of the images (*e.g.*, to assist with the image acquisition) and/or after the image acquisition is completed - as part of doing so, the automated operations may further include identifying structural and other visual features of the rooms, including walls/floors/ceilings and borders between them, inter-room passages (*e.g.*, doorways, non-doorway openings, stairs, halls, etc.), and other structural elements (*e.g*., windows, fireplaces, islands, etc.), and using such information as part of joining room shapes together as part of generating a building floor plan. For example, generation of a floor plan for the building and optionally other associated mapping information may include using the inter-room passage information and other information to determine relative global positions of the associated room shapes to each other in a common coordinate system or other common frame of reference (*e.g.*, without knowing the actual measurements of the rooms) - in addition, if distance scaling information is available for one or more of the images, corresponding distance measurements may be determined, such as to allow room sizes and other distances to be determined and further used for the generated floor plan. A generated floor plan may, for example, include a 2D overview view or other formats (*e.g*., a 3D, or three-dimensional, model), and other types of mapping information may include, for example, a virtual tour of inter-connected images (*e.g*., 360° panorama images) with directional information in each image to one or more other images (*e.g*., user-selectable links to other nearby images). Additional details are included below related to such generation and use of floor plans and/or other building mapping information based on images and/or their associated acquisition metadata.

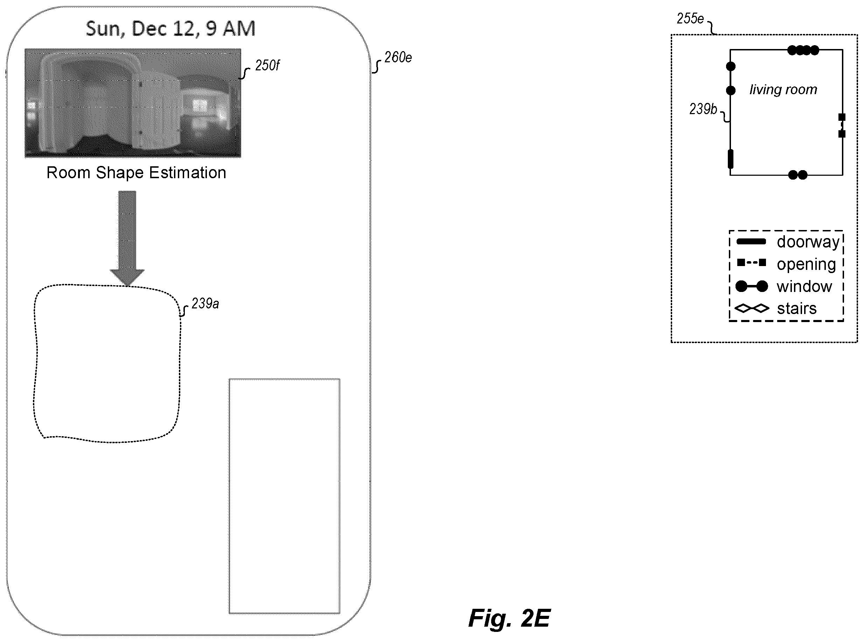

In addition, the automated operations of the computing device(s) to provide the described techniques may in some embodiments and situations further include operations of the ABIA system to analyze and assess building images as part of performing an automated assessment of characteristics of an associated automated mapping information generation process that is based at least in part on those images, such as to assess, for example, a predicted amount of time for the automated generation process to complete, and to provide instructions or other feedback (*e.g*., to one or more users participating in the image acquisition process) to reduce that amount of time and/or otherwise improve the generation process - in at least some such embodiments, ICA and/or MIGM systems may be part of the ABIA system, or the ABIA system may otherwise direct some or all operations of the ICA and/or MIGM systems, while in other embodiments the ABIA system may instead receive and use images and/or floor plan information from other separate sources. For example, the ABIA system may in at least some embodiments, as each image is acquired for use in producing a floor plan and/or other mapping information for a building, assess the visual data of the image (and optionally other information related to the image, such as image acquisition metadata) to determine quality and/or other attributes of the image (*e.g*., with respect to attributes that affect the generation process for the floor plan), and provide corresponding instructions feedback and/or other feedback (*e.g.*, automated instructions, such as to automatically change image acquisition device settings and/or other parameters, such as lighting, rotation speed and/or height of equipment on which the image acquisition device rests or is mounted, etc.; instructions or other feedback to one or more users involved in acquiring the image, such as to a photographer user about one or more problems with the current image to cause improvement in acquisition of one or more subsequent images and/or improvement in reacquiring a new image to replace the current image; etc.). At least some such instructions feedback or other feedback may be provided to the one or more users involved in acquiring the image in one or more manners, such as to display the feedback in a displayed GUI (*e.g*., on the image acquisition device, such as if it is a smart phone or other image acquisition computing device that includes computing capabilities and image acquisition capabilities; on another device of the user(s), etc.). In at least some such embodiments, additional information may further be provided to the user(s) along with the feedback, such as to display in the GUI one or more of the following: an initial room shape determination of the room containing the current image's acquisition location based at least in part on the visual data of the current image (*e.g.*, an initial room shape determined on the image acquisition device); a final room shape determination for that room (*e.g.*, determined on one or more remote computing devices to which the current image and any associated acquisition metadata is transmitted); a partial version of the floor plan and/or other mapping information generated from the current image and any prior images acquired for the building; etc. - in addition, once the acquisition of the images for the building is complete (*e.g*., at the end of one or more image acquisition sessions in the building to acquire the images), a final version of the floor plan and/or other mapping information generated for the building from the set of acquired images may similarly be displayed in the GUI and/or otherwise provided to the user(s) involved in the image acquisition and/or to other users. Such provided feedback may then cause improvement in the generation process for the floor plan and/or other mapping information for the building (*e.g*., a reduction in the predicted and/or actual time until completion of the generation process and/or other predicted and/or actual characteristic of the generation process), such as to cause reacquisition of a current image due to its problems (*e.g.*, in an automated manner without human interaction, based on prompting a human user to perform the reacquisition, etc.) that results in a new improved replacement image lacking some or all of those problems, to cause improvement in the acquisition of one or more subsequent images for the building (*e.g*., in an automated manner without human interaction, such as to automatically change settings of the image acquisition equipment and/or to otherwise modify a surrounding environment for subsequent images, such as with respect to lighting and/or by determining additional acquisition locations at which to acquire subsequent images; based on prompting a human user to perform the acquisition of the subsequent images in a manner that reduces or eliminates the problem; etc.), to cause changes in the generation process for the building's mapping information (*e.g.*, to use more and/or different resources, to change types of processing techniques, etc.), etc. Additional details are included below related to such determination and providing of feedback, including with respect to non-exclusive examples of Figures 2E-2K.

With respect to assessing the visual data of a target image (and optionally other information related to the image, such as image acquisition metadata) to determine quality and/or other attributes of the image, such as for a most recently acquired image and with respect to attributes that affect the generation process of a floor plan or other building mapping information based in part on that visual data, non-exclusive examples of attributes of the target image that may be assessed and further used include one or more of the following: attributes of the visual data and its capture (*e.g*., lighting, blurriness/motion, etc.); relationship of the visual data of that target image to one or more other acquired images, such as prior and/or subsequent images (*e.g.*, whether and/or how much inter-image line-of-sight exists between the target image's visual data and that of at least one other acquired image; or whether and/or how much inter-image overlap exists between the target image's visual data and that of at least one other acquired image; or a quantity of acquired images (*e.g.*, below a defined minimum threshold, above a defined maximum threshold, etc.); or a distance between an acquisition location of the target image and at least one wall; or whether and/or how much line-of-sight exists through at least one doorway in the target image's visual data; or visibility of at least a portion of equipment used in acquiring the target image, such as a tripod or other equipment on which a camera or other image acquisition device rests or is mounted; or changes to equipment used in acquiring the target image relative to acquiring one or more other images, such as a change in height from the floor, image acquisition device settings or other parameters, etc.; or visibility of at least a portion of a user involved in acquiring the target image; or visibility of obstructions in the target image's visual data that block visibility of one or more walls, such as furniture, walls, etc.; or a lack of coverage of all of the multiple rooms; or a lack of coverage of all of at least one of the multiple rooms, such as all of the walls; or uncertainty in determination of a room shape of at least one of the multiple rooms based on the target image's visual data; or an inability to and/or uncertainty associated with detection of one or more windows and/or doorways and/or non-doorway wall openings in the target image's visual data; etc.). Additional details are included below related to such determination and use of information about acquired images and their contribution to the generation process for producing a floor plan and/or other mapping information, including with respect to the non-exclusive examples of Figures 2E-2K.

With respect to assessing characteristics of the automated mapping information generation process for a floor plan and/or other mapping information for a building (*e.g.*, to assess a predicted amount of time for the automated generation process to complete), such as based on one or more acquired target images for the building (*e.g*., a subset of a full set of images to be acquired for the building) and optionally on expected additional images to be acquired in the future (*e.g.*, during an ongoing image acquisition session that is not yet completed), non-exclusive examples of information that may be assessed and further used include one or more of the following: a size of the building (*e.g*., square feet) and/or of the associated external area (*e.g*., of the property on which the building is located); or a style and/or type of the building (*e.g*., mid-century modern, ranch, Cape Cod, colonial, contemporary, cottage, bungalow, craftsman, farmhouse, etc.; single-family, duplex, triplex, apartment, condominium, town house or townhome, tiny house, manufactured house, prefabricated house, 3D-printed house, mobile home, etc.); or a number of stories and/or levels of the building; or a number of rooms of the building (*e.g.*, of any type, or one or more indicated types, etc.); or one or more types of one or more rooms of the building; or one or more types of one or more walls of the building (*e.g*., flat, curved, non-continuous 2D surfaces, etc.); or whether the building is furnished; or data available from one or more sensors of one or more types on one or more image acquisition devices used for acquiring the target images (*e.g.*, GPS and/or other location data, depth data to surrounding surfaces, etc.); or a quantity of the target images; or an amount of coverage of all of the multiple rooms by visual data of the target images; or uncertainty in determination of room shapes of the multiple rooms based on visual data of the target images; or detection of at least one of windows or doorways or non-doorway wall openings in visual data of the target images; or an amount of computing resources available for producing the mapping information for the building; or availability of one or more users to assist in the producing of the mapping information; or information about at least one user involved in acquiring the target images (*e.g.*, experience level or other attribute(s) associated with ability of the user to acquire images that contribute to generating mapping information; historical information about automated generation of mapping information for other buildings using images acquired by the user; one or more preferences of the user and/or instructions received from the user that affect the generation of the mapping information from the target image(s), such as one of multiple levels of quality or other characteristics of the generated mapping information, a requested rush status for the generation of the mapping information, etc.; a priority level associated with the user, such as corresponding to a subscription or membership status of the user that affects how the generation of the mapping information for the user is performed relative to other activities (*e.g*., the generation of other mapping information for other users), including to change an order of processing for the user relative to an order based on receipt of acquired images or a mapping information generation request; or about one or more other buildings having similarities to the building (*e.g*., for use in comparative estimates); etc. In addition, in at least some embodiments and situations, characteristics of the automated generation process other than a predicted amount of time until completion may be assessed and used, with non-exclusive examples including the following: a predicted amount of time until a stage of the generation process other than completion; a predicted amount of resources used to reach completion or other stage of the generation process (*e.g.*, an amount of CPU cycles or storage or other measure of computing resources; an amount of time of one or more human MIGM and/or ABIA operator users to participate in the generation process, or other characteristics of such user(s); a cost involved in the use of the resources, such as monetary and/or non-monetary costs; etc.); one or more characteristics measured with respect to one or more other defined metrics; etc. Additional details are included below related to such determination and use of information about characteristics of the generation process for producing a floor plan and/or other mapping information, including with respect to the non-exclusive examples of Figures 2E-2N.

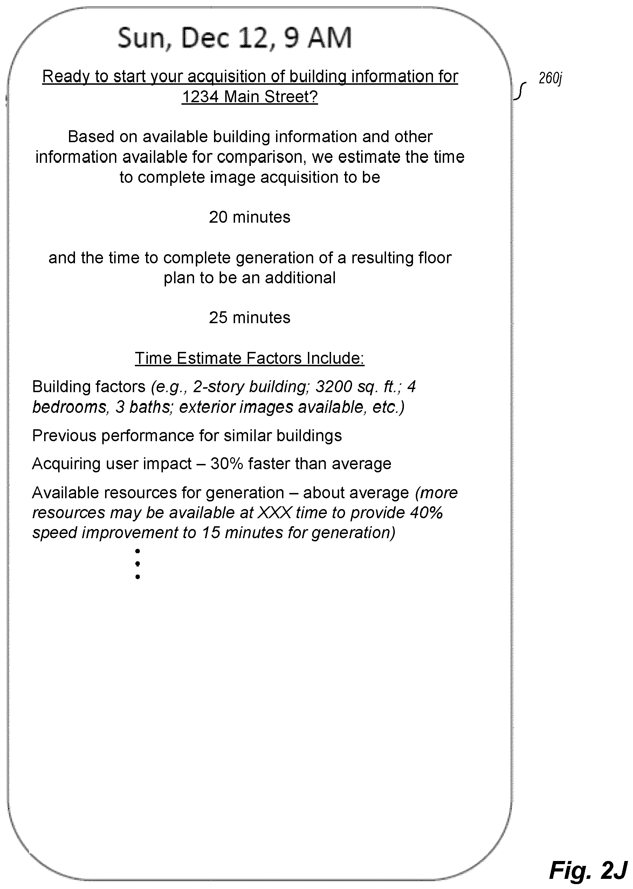

In addition, in at least some embodiments, the ABIA system may perform further types of automated operations to improve the generation process of mapping information for a building based at least in part on visual data of images acquired for the building, including to determine and provide additional types of feedback (*e.g*., to one or more users involved in the acquisition process of some or all of the images for the building, such as by displaying the additional feedback to the user(s) in one or more displayed GUIs). As one non-exclusive example, the ABIA system may, before acquiring any images for use in the generation process of mapping information for a building, determine and provide an initial estimate of the predicted amount of time for completion of the generation process and/or other predicted characteristic of the generation process, such as based on any or all of the factors discussed above that are not based on visual data of acquired images from a building's interior (*e.g*., based on publicly available information about the building, such as size, style/type, information about rooms, etc.; based on the one or more users involved in the image acquisition process, such as based on historical results for the user(s) and/or experience or other related attribute(s) of the user(s) and/or on preferences or instructions of the user(s) and/or on generation process priority associated with the user(s); based on images of an exterior of the building and/or its associated property that are not used in the generation process, such as from a satellite or otherwise overhead images such as from a drone and/or airplane, or from a street or other exterior location; etc.). As another non-exclusive example, whether in addition to or instead of providing the initial estimate(s) of the characteristic(s) of the generation process, the ABIA system may determine and provide one or more types of status information during the image acquisition process (*e.g.*, during one or more image acquisition sessions in which the images for use in the generation process are acquired), such as to represent an amount of the image acquisition process that is completed and/or is remaining (*e.g*., a predicted or otherwise estimated percentage or other amount that is completed and/or remaining, such as a quantity of time used and/or until completion, a percentage completed and/or remaining, an amount of square feet and/or quantity of rooms and types of rooms completed and/or remaining, etc.). Additional details are included below related to such determination and use of additional types of feedback, including with respect to the non-exclusive examples of Figures 2J-2K.

As noted above, the described techniques may include automated operations of the MIGM system to implement an automated generation process to produce a floor plan and/or other mapping information for a building based at least in part on the visual data of images acquired at multiple acquisition locations in and optionally around the building. In at least some embodiments and situations, room shape and/or layout information for a room may be determined that includes a shape of the room (*e.g*., a 2D overhead view of a rectangular shape or other shape of walls of the room) and/or locations of inter-room wall openings in the room, optionally along with additional information such as types of inter-room wall openings (*e.g*., a door or stair or other inter-room wall opening), sizes of inter-room wall openings (*e.g*., width and/or height), types of the rooms (*e.g*., kitchen, bathroom, bedroom, etc.), dimensions of the rooms (*e.g.*, widths and/or heights of each of the walls), etc. Some or all such room layout information for a room may be determined from one or more images captured in the room in various manners in various embodiments, such as by applying machine learning techniques to automatically assess the image(s) (*e.g*., supplying the image(s) as input to one or more neural networks that have been trained using other images and associated room layout information to identify one or more such types of room layout information, and obtaining the corresponding room layout information as output from the trained neural networks), and/or by using information supplied by one or more users (*e.g.*, MIGM system operator users) that assess the image(s) to determine some or all of the room layout information. In some embodiments in which acquisition metadata for an image captured at an acquisition location in a room includes depth data from one or more depth sensors at the acquisition location to surrounding walls or other objects of the room, such depth information may be used to determine some or all such room layout information, whether by using such depth information together with other of the described image assessment techniques or instead using only such depth information. Thus, such assessment techniques of one or more images acquired in a room may provide various types of room information in various embodiments and situations, including to identify structural and other visual features of the room, such as to identify one or more of the following: borders between adjacent walls; borders between walls and a floor; borders between walls and a ceiling; windows and/or sky-lights; passages into and/or out of the room, such as doors and stairs and other wall openings; other structures (*e.g.*, represented as cuboid shapes), such as countertops, bath tubs, sinks, fireplaces, and furniture; etc.

In addition, the automated operations of the MIGM system to implement an automated generation process to produce a floor plan and/or other mapping information for a building may further include interacting with one or more MIGM system operator users who assist with the generating of the mapping information (*e.g.*, by displaying one or more GUIs that show information related to the images and/or that show associated mapping information being generated; by receiving and using input submitted by the user(s) via the GUI(s) as part of the mapping information generation, such as corrected to initial automatically determined information; etc.). As one non-exclusive example, one or more MIGM system operator users may, in at least some embodiments, manipulate displayed information in the GUI about two or more rooms in order to identify and/or confirm interconnections between the rooms via passages into and/or out of the rooms, such as doors and other openings in walls of the rooms (*e.g*., inter-room wall openings such as doors, stairs and other non-door wall openings between rooms; other wall openings that are not between two rooms, such as exterior windows and exterior doors; etc.) - in addition, in at least such embodiments, such user manipulations via the GUI may further modify and otherwise control how rooms are interconnected, such as to specify a width of walls between rooms, to control alignment of room shapes relative to each other, etc., and/or may otherwise specify information about rooms or about a floor plan being generated. In some embodiments, such displayed information in the GUI may include displayed panorama images of one or more of the rooms in one or more distinct sections or 'panes' of the GUI, with additional displayed information overlaid on some or all of those displayed panorama images to show information about one or more other rooms (*e.g*., an outline of some or all borders of a second room that is overlaid on a panorama image of a first room in a location within the image at which that second room would be situated if connected to the first room via specified connected inter-room openings of the two rooms). In addition, in some embodiments, such displayed information may include a displayed floor plan pane of the GUI that shows room shapes of two or more rooms in locations relative to each other that reflect the rooms being connected via specified inter-room openings of the rooms (*e.g*., a 2D overhead view outline of the walls and wall openings for the room, with the connected inter-room openings being located adjacent to or on top of each other, and optionally to have walls of the two rooms that are within a defined threshold amount of being parallel being adjusted to be parallel). In such embodiments with multiple panes each showing different information (*e.g.*, a first pane showing a first panorama image of a first room with a first inter-room opening; a second pane showing a second panorama image of a second room with a second inter-room opening to potentially connect to the first room via a connection between the first and second inter-room openings, such as to show that the first and second inter-room openings are two sides of the same wall opening between the first and second rooms; a third pane showing a floor plan view with room shapes of at least the first and second rooms, and possibly other connected rooms; and optionally one or more additional panes showing additional panorama images of additional rooms to potentially connect to one or more of the first and second rooms), the displayed information between the panes may be coordinated in the GUI, such as to simultaneously update corresponding information in other panes as a user manipulates information in one of the panes (*e.g.*, to change relative locations of the first and second rooms as the user adjusts location of at least one of the rooms in one of the panes). Additional details are included below related to such GUIs and associated user interactions techniques for use in generating floor plans.

Additional details are included below regarding further automated operations of computing device(s) implementing an ABIA system as part of performing additional automated analyses of information about the buildings and/or information received from system operator user(s), as well as in interacting with the system operator user(s). In some embodiments, one or more types of additional processing may be further performed, such as to determine additional mapping-related information for a generated floor plan or to otherwise associate additional information with a generated floor plan. As one example, one or more types of additional information about a building may be received and associated with the floor plan (*e.g.*, with particular locations in the floor plan), such as additional images, textual and/or audio annotations or other descriptions of particular rooms or other locations, other audio information, such as recordings of ambient noise; overall dimension information, etc. As another example, in at least some embodiments, additional processing of images is performed to determine estimated distance information of one or more types, such as to measure sizes in images of objects of known size, and use such information to estimate room width, length and/or height dimensions - such estimated size information for one or more rooms may be associated with the floor plan, stored and optionally displayed, and if the size information is generated for all rooms within a sufficient degree of accuracy, a more detailed floor plan of the building may further be generated, such as with sufficient detail to allow blueprints or other architectural plans to be generated. In addition, if estimated size information includes height information from floors to ceilings, a 3D (three-dimensional) model (*e.g.*, with full height information represented) and/or 2.5D (two-and-a-half dimensional) model (*e.g*., with partial representations of height shown) of some or all of the 2D (two-dimensional) floor plan may be created (optionally with information from in-room images projected on the walls of the models), associated with the floor plan, stored and optionally displayed. Other types of additional information may be generated or retrieved and used in some embodiments, such as to determine a geographical alignment for a building (*e.g.*, with respect to true north or magnetic north) and/or geographical location for a building (*e.g.*, with respect to latitude and longitude, or GPS coordinates; for a street address; etc.), and to optionally include corresponding information on its generated floor plan and/or other generated mapping-related information, and/or to optionally further align the floor plan or other generated mapping-related information with other associated external information (*e.g.*, satellite or other external images of the building, including street-level images to provide a 'street view' of the building and/or panorama images acquired at one or more locations in a yard or other area around a building; information for an area in which the building is located, such as nearby street maps and/or points of interest; etc.). Other information about the building may also be retrieved from, for example, one or more external sources (*e.g*., online databases, 'crowd-sourced' information provided by one or more end users, etc.), and associated with and linked to the floor plan and/or to particular locations within the floor plan - such additional information may further include, for example, exterior dimensions and/or shape of the building, additional images and/or annotation information acquired corresponding to particular locations within the building (optionally for locations different from acquisition locations of the acquired panorama or other images), etc. Such generated floor plans and optionally additional associated information may further be used in various manners, as discussed elsewhere herein.

The described techniques provide various benefits in various embodiments, including to allow floor plans of multi-room buildings and other structures to be generated from images acquired in the buildings or other structures via automated operations of one or more computing systems, including in some embodiments without having or using acquired depth information from depth sensors about distances from images' acquisition locations to walls or other objects in a surrounding building or other structure. Furthermore, such automated techniques allow such a floor plan to be generated much more quickly than previously existing techniques, and in at least some embodiments with greater accuracy, based at least in part on using information acquired from the actual building environment (rather than from plans on how the building should theoretically be constructed), including based on using 360° panorama images in an equirectangular format that display an entire room and allow efficient user identification of elements of interest in the room, as well as enabling the capture of changes to structural elements that occur after a building is initially constructed, and including in some embodiments to perform automated operations to interact with one or more users to obtain one or more types of user-supplied input that is used for further automated analysis. Such described techniques further provide benefits in allowing improved automated navigation of a building by mobile devices (*e.g.*, semi-autonomous or fully-autonomous vehicles), including to significantly reduce their computing power used and time used to attempt to otherwise learn a building's layout. In addition, in some embodiments the described techniques may be used to provide an improved GUI in which an end user may more accurately and quickly obtain information about a building's interior (*e.g.*, for use in navigating that interior, such as via a virtual tour), including in response to search requests, as part of providing personalized information to the end user, as part of providing value estimates and/or other information about a building to an end user, etc. Various other benefits are also provided by the described techniques, some of which are further described elsewhere herein.

For illustrative purposes, some embodiments are described below in which specific types of information are acquired, used and/or presented in specific ways for specific types of structures and by using specific types of devices - however, it will be understood that the described techniques may be used in other manners in other embodiments, and that the invention is thus not limited to the exemplary details provided. As one non-exclusive example, while floor plans may be generated for houses that do not include detailed measurements for particular rooms or for the overall houses, it will be appreciated that other types of floor plans or other mapping information may be similarly generated in other embodiments, including to generate 3D model floor plans, and to do so for buildings (or other structures or layouts) separate from houses. As another non-exclusive example, while certain types of images may be discussed in certain examples (*e.g*., 360° panorama images), it will be appreciated that other types of images (including video frames) and visual data may be similarly used in some embodiments, whether in addition to or instead of such image types. As yet another non-exclusive example, while floor plans for houses or other buildings may be used for display to assist viewers in navigating the buildings, generated mapping information may be used in other manners in other embodiments. In addition, the term "building" refers herein to any partially or fully enclosed structure, typically but not necessarily encompassing one or more rooms that visually or otherwise divide the interior space of the structure - non-limiting examples of such buildings include houses, apartment buildings or individual apartments therein, condominiums, office buildings, commercial buildings or other wholesale and retail structures (*e.g.*, shopping malls, department stores, warehouses, etc.), etc. The terms "acquire" or "capture" as used herein with reference to a building interior, acquisition location, or other location (unless context clearly indicates otherwise) may refer to any recording, storage, or logging of media, sensor data, and/or other information related to spatial and/or visual characteristics of the building interior or subsets thereof, such as by a recording device and/or by another device that receives information from the recording device. In addition, various details are provided in the drawings and text for exemplary purposes, but are not intended to limit the scope of the invention. For example, sizes and relative positions of elements in the drawings are not necessarily drawn to scale, with some details omitted and/or provided with greater prominence (*e.g.*, via size and positioning) to enhance legibility and/or clarity. Furthermore, identical reference numbers may be used in the drawings to identify similar elements or acts.

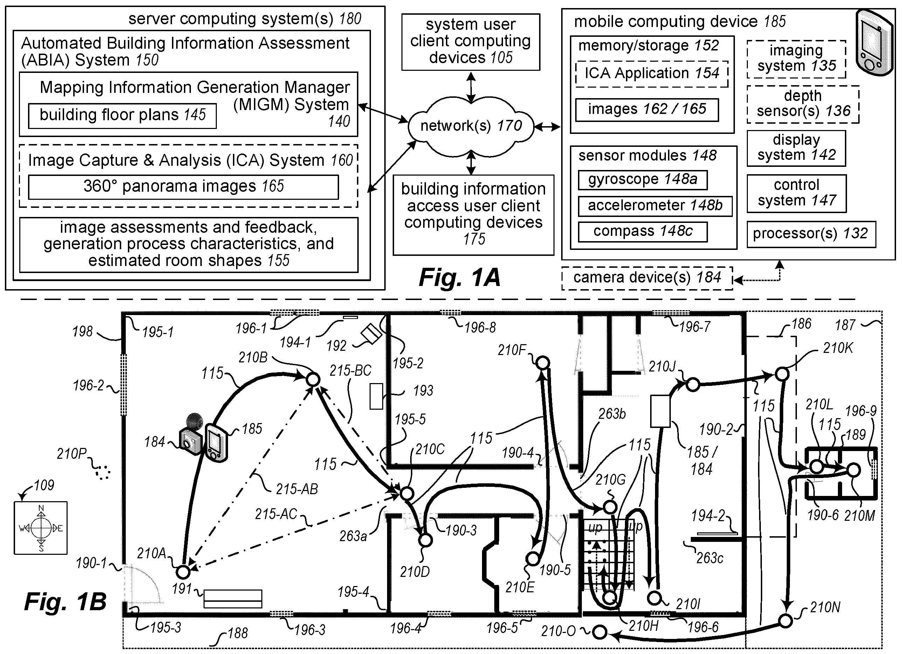

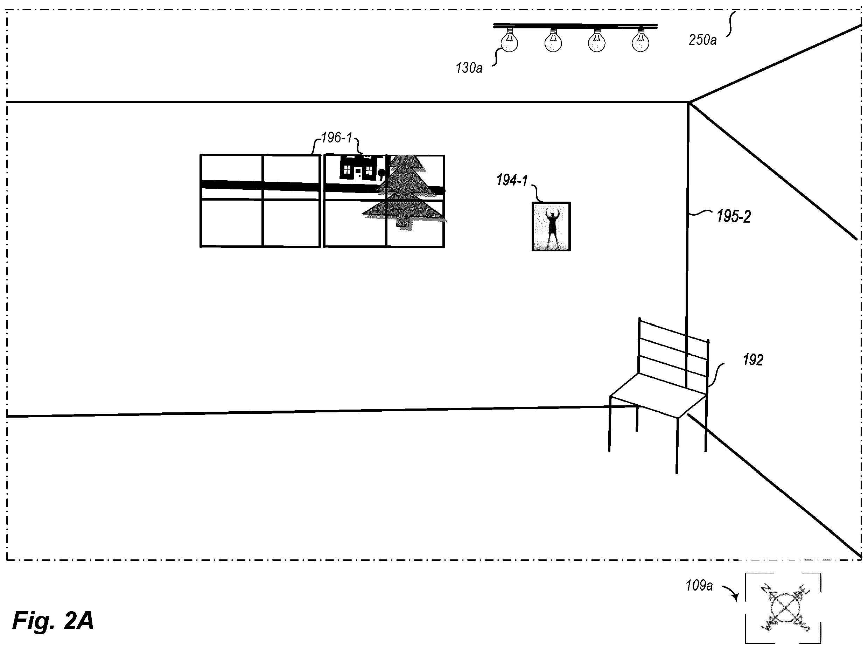

Figure 1A is an example block diagram of various computing devices and systems that may participate in the described techniques in some embodiments. In particular, one or more 360° panorama images 165 (*e.g*., in equirectangular format) have been generated by an Interior Capture and Analysis ("ICA") system (*e.g.*, a system 160 that is executing on one or more server computing systems 180, and/or a system provided by application 154 executing on one or more mobile computing devices 185), such as with respect to one or more buildings or other structures - Figure 1B shows one example of acquisition of such panorama images for a particular house at multiple acquisition locations 210, and Figures 2A-2N illustrate additional details about using such panorama images to generate an associated floor plan, as discussed further below.

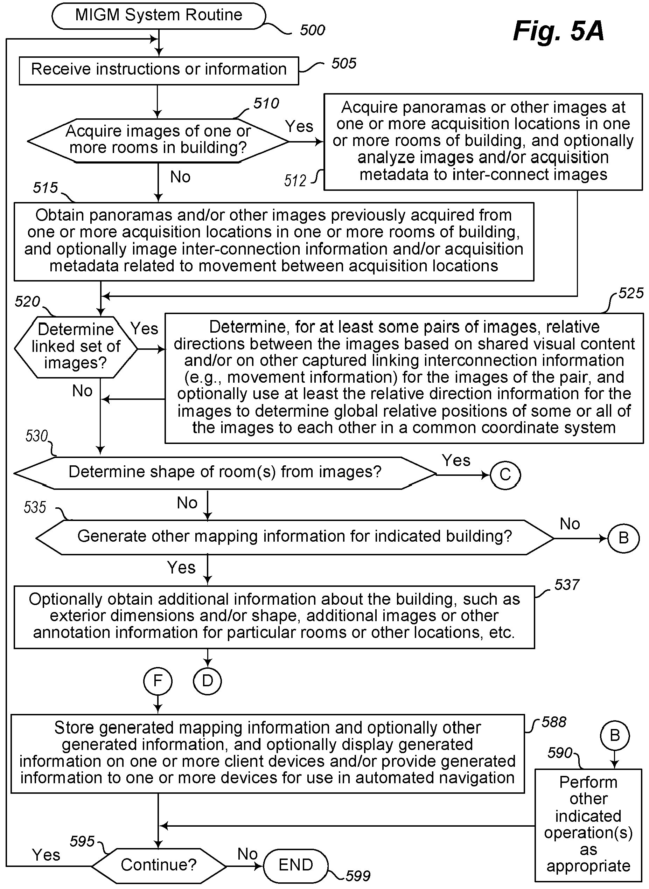

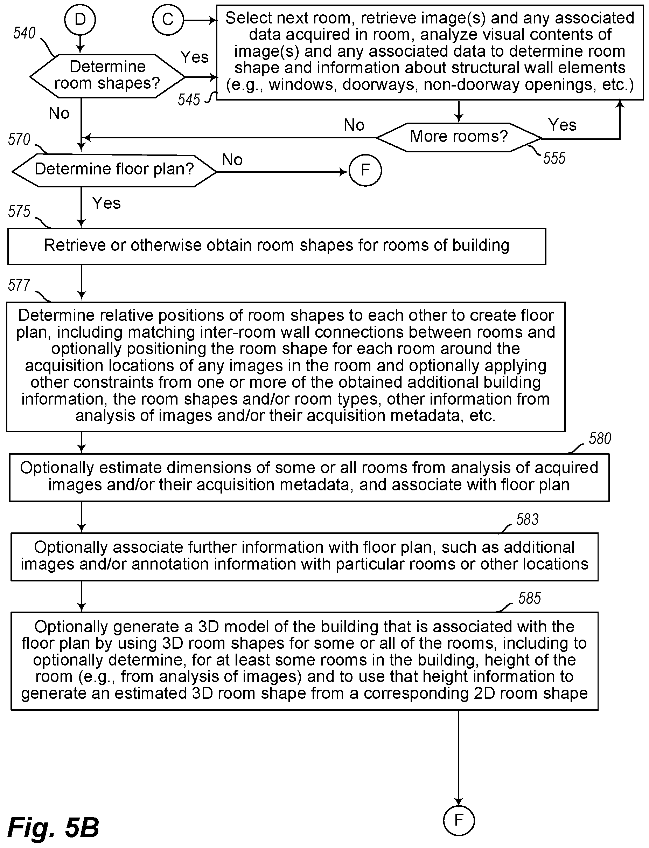

A MIGM (Mapping Information Generation Manager) system 140 is further executing on one or more server computing systems 180 to generate and provide building floor plans 145 and/or other mapping-related information (not shown) based on use of the panorama images 165 and optionally additional associated information, as well as by optionally using supporting information supplied by system operator users via computing devices 105 over intervening computer network(s) 170 - additional details related to the automated operation of the MIGM system are included elsewhere herein, including with respect to Figures 2A-2N and 5A-5B. In some embodiments, the ICA system 160 and MIGM system 140 may execute on the same server computing system(s), such as if both systems are operated by a single entity or are otherwise executed in coordination with each other (*e.g*., with some or all functionality of both systems integrated together into a larger system), while in other embodiments the MIGM system may instead operate without an ICA system and instead obtain panorama images (or other images) from one or more external sources and optionally store them locally (not shown) with the MIGM system for further analysis and use.

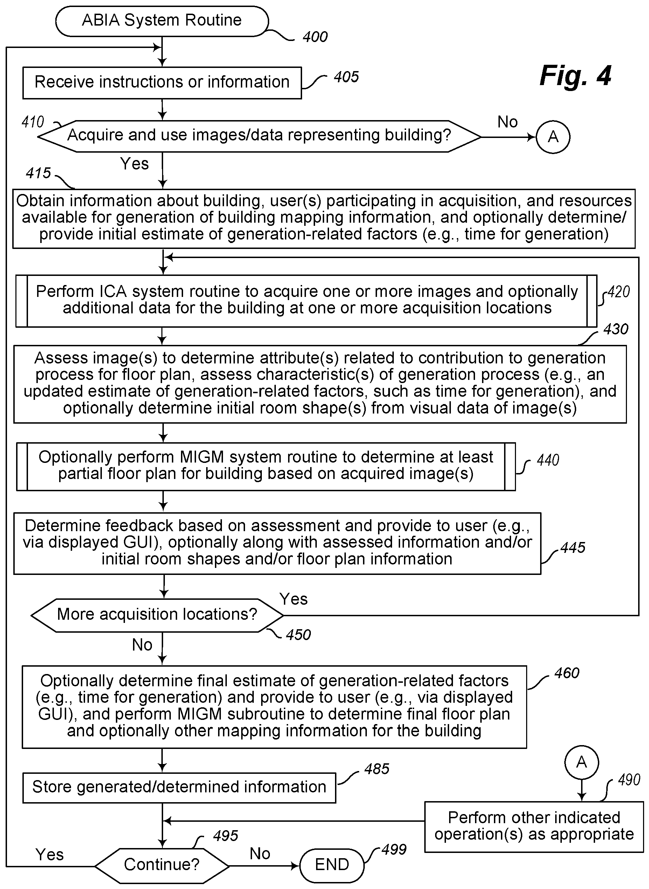

In addition, in the illustrated embodiment, the ICA system 160 and MIGM system 140 are operating as part of an ABIA (Automated Building Information Assessment) system 150 that is executing on one or more server computing systems 180 to analyze and assess acquired images (*e.g*., images 165 acquired by the ICA system) as part of performing an automated assessment of characteristics 155 of an automated mapping information generation process (*e.g.*, automated operations of the MIGM system to generated a building floor plan 145), such as to assess, for example, a predicted amount of time for the automated generation process to complete and to provide automated instructions and/or other feedback 155 (*e.g*., to adjust image acquisition device settings or parameters) to reduce that amount of time or otherwise improve the generation process, as well as by optionally using supporting information supplied by system operator users via computing devices 105 over intervening computer network(s) 170 - additional details related to the automated operation of the ABIA system are included elsewhere herein, including with respect to Figures 2E-2N and 4. In addition, at least some such feedback may, for example, be displayed to one or more users of a mobile computing device 185 that acquires at least some of the images 165 (*e.g.*, a mobile image acquisition computing device 185 that includes one or more imaging systems 135 to acquire images 162 and/or 165) and/or that receives at least some of the images 162 and/or 165 from one or more optional associated camera devices 184. In other embodiments, some or all of the ABIA system may instead execute on a mobile image acquisition computing device 185 in conjunction with an image acquisition process that acquires images 162 and/or 165 for use in a corresponding automated building mapping information generation process, such as to perform assessments and determine initial room shape estimates and provide feed on the computing device 185, while optionally interacting over one or more computer networks with one or more other systems (*e.g.*, a MIGM system 140 executing on the one or more server computing systems 180).

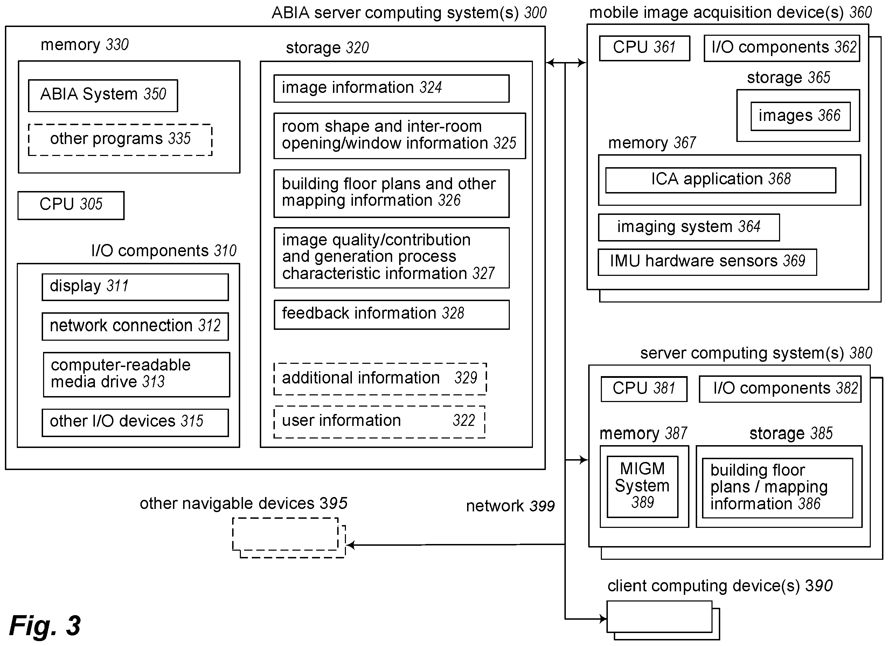

Various components of the mobile computing device 185 are also illustrated in Figure 1A, including an optional ICA system application 154 that is executed in memory 152 of the device 185 by one or more hardware processors 132, and optionally including one or more imaging systems 135 of one or more types to acquire visual data of one or more images 162 (*e.g.*, rectilinear perspective images) and/or 165 - some or all such images 162 and/or 165 may in some embodiments be supplied by one or more separate associated camera devices 184 (*e.g.*, via a wired/cabled connection, via Bluetooth or other inter-device wireless communications, etc.), whether in addition to or instead of images captured by the mobile device 185. The illustrated embodiment of mobile device 185 further includes one or more sensor modules 148 that include a gyroscope 148a, accelerometer 148b and compass 148c in this example (*e.g.*, as part of one or more IMU units, not shown separately, on the mobile device), optionally a GPS (or Global Positioning System) sensor or other position determination sensor (not shown in this example), optionally one or more depth-sensing sensors or other distance-measuring components 136 of one or more types, a display system 142 (*e.g.,* with a touch-sensitive screen), one or more control systems 147 managing I/O (input/output) and/or communications and/or networking for the device 185 (*e.g*., to receive instructions from and present information to the user), etc. Other computing devices/systems 105, 175 and 180 and/or camera devices 184 may include various hardware components and stored information in a manner analogous to mobile device 185, which are not shown in this example for the sake of brevity, and as discussed in greater detail below with respect to Figure 3.

In the example of Figure 1A, the ICA system may perform automated operations involved in generating multiple 360° panorama images at multiple associated acquisition locations (*e.g.*, in multiple rooms or other locations within a building or other structure and optionally around some or all of the exterior of the building or other structure), such as using visual data acquired via the mobile device(s) 185 and/or associated camera devices 184, and for use in generating and providing a representation of an interior of the building or other structure. For example, in at least some such embodiments, such techniques may include using one or more mobile devices (*e.g.*, a camera having one or more fisheye lenses and mounted on a rotatable tripod or otherwise having an automated rotation mechanism, a camera having sufficient fisheye lenses to capture 360 degrees horizontally without rotation, a smart phone held and moved by a user, a camera held by or mounted on a user or the user's clothing, etc.) to capture data from a sequence of multiple acquisition locations within multiple rooms of a house (or other building), and to optionally further capture data involved in movement of the acquisition device (*e.g.*, movement at an acquisition location, such as rotation; movement between some or all of the acquisition locations, such as for use in linking the multiple acquisition locations together; etc.), in at least some cases without having distances between the acquisition locations being measured or having other measured depth information to objects in an environment around the acquisition locations (*e.g.*, without using any depth-sensing sensors). After an acquisition location's information is captured, the techniques may include producing a 360° panorama image from that acquisition location with 360 degrees of horizontal information around a vertical axis (*e.g*., a 360° panorama image that shows the surrounding room in an equirectangular format), and then providing the panorama images for subsequent use by the MIGM and/or ABIA systems.

One or more end users (not shown) of one or more map viewer client computing devices 175 may further interact over computer networks 170 with the ABIA system 150 (and optionally the MIGM system 140 and/or ICA system 160), such as to obtain, display and interact with a generated floor plan (and/or other generated mapping information) and/or associated images. In addition, while not illustrated in Figure 1A, a floor plan (or portion of it) may be linked to or otherwise associated with one or more additional types of information, such as one or more associated and linked images or other associated and linked information, including for a two-dimensional ("2D") floor plan of a building to be linked to or otherwise associated with a separate 2.5D model rendering of the building and/or a 3D model rendering of the building, etc., and including for a floor plan of a multi-story or otherwise multi-level building to have multiple associated sub-floor plans for different stories or levels that are interlinked (*e.g.*, via connecting stairway passages) or are part of a common 2.5D and/or 3D model. Accordingly, non-exclusive examples of an end user's interactions with a displayed or otherwise generated 2D floor plan of a building may include one or more of the following: to change between a floor plan view and a view of a particular image at an acquisition location within or near the floor plan; to change between a 2D floor plan view and a 2.5D or 3D model view that optionally includes images texture-mapped to walls of the displayed model; to change the horizontal and/or vertical viewing direction from which a corresponding subset view of (or portal into) a panorama image is displayed, such as to determine a portion of a panorama image in a 3D coordinate system to which a current user viewing direction is directed, and to render a corresponding planar image that illustrates that portion of the panorama image without the curvature or other distortions present in the original panorama image; etc. In addition, while not illustrated in Figure 1A, in some embodiments the client computing devices 175 (or other devices, not shown) may receive and use generated floor plans and/or other generated mapping-related information in additional manners, such as to control or assist automated navigation activities by those devices (*e.g.*, by autonomous vehicles or other devices), whether instead of or in addition to display of the generated information.

In the depicted computing environment of Figure 1A, the network 170 may be one or more publicly accessible linked networks, possibly operated by various distinct parties, such as the Internet. In other implementations, the network 170 may have other forms, such as to instead be a private network (such as a corporate or university network) that is wholly or partially inaccessible to non-privileged users. In still other implementations, the network 170 may include both private and public networks, with one or more of the private networks having access to and/or from one or more of the public networks. Furthermore, the network 170 may include various types of wired and/or wireless networks and connections in various situations.

Figure 1B depicts a block diagram of an exemplary building interior environment in which 360° panorama images and/or other images are acquired, for use by the MIGM system to generate and provide a corresponding building floor plan and by the ABIA system to perform an automated assessment of characteristics of the floor plan generation process based at least in part on assessment of attributes of the images, as discussed in greater detail with respect to Figures 2A-2N, as well as for use in presenting the images to users. In particular, Figure 1B illustrates one story of a multi-story house (or other building) 198 with an interior that was captured at least in part via multiple panorama images, such as by a mobile image acquisition device 185 with image acquisition capabilities and/or one or more associated camera devices 184 as they are moved through the building interior to a sequence of multiple acquisition locations 210 (*e.g.*, starting at acquisition location 210A, moving to acquisition location 210B along travel path 115, etc., and ending at acquisition location 210-O or 210P outside of the building). An embodiment of the ICA system (*e.g*., ICA system 160 on server computing system(s) 180, a copy 154 of some or all of the ICA system executing on the mobile image acquisition device 185, etc.) may automatically perform or assist in the capturing of the data representing the building interior, as well as to further analyze the captured data to generate 360° panorama images to provide a visual representation of the building interior, and the ABIA system may determine and provide feedback regarding some or all of the acquired images and/or the image acquisition process (*e.g.*, via the ICA system, directly via the mobile devices 185 and/or 184, etc.). While such a mobile image acquisition device may include various hardware components, such as a camera, one or more sensors (*e.g.*, a gyroscope, an accelerometer, a compass, etc., such as part of one or more IMUs, or inertial measurement units, of the mobile device; an altimeter; light detector; etc.), a GPS receiver, one or more hardware processors, memory, a display, a microphone, etc., the mobile device may not in at least some embodiments have access to or use equipment to measure the depth of objects in the building relative to a location of the mobile device, such that relationships between different panorama images and their acquisition locations in such embodiments may be determined in part or in whole based on features in different images but without using any data from any such depth sensors, while in other embodiments such depth data may be used. In addition, while directional indicator 109 is provided in Figure 1B for reference of the reader, the mobile device and/or ICA system may not use such absolute directional information and/or absolute locations in at least some embodiments, such as to instead determine relative directions and distances between acquisition locations 210 without regard to actual geographical positions or directions in such embodiments, while in other embodiments such absolute directional information and/or absolute locations may be obtained and used.

In operation, the mobile device 185 and/or camera device(s) 184 arrive at a first acquisition location 210A within a first room of the building interior (in this example, in a living room accessible via an external door 190-1), and captures a view of a portion of the building interior that is visible from that acquisition location 210A (*e.g.*, some or all of the first room, and optionally small portions of one or more other adjacent or nearby rooms, such as through doorways, non-doorway wall openings, hallways, stairways or other connecting passages from the first room). The view capture may be performed in various manners as discussed herein, and may include a number of objects or other features (*e.g*., structural details) that may be visible in images captured from the acquisition location - in the example of Figure 1B, such objects or other features within the building include the doorways 190 (including 190-1 through 190-5, such as with swinging and/or sliding doors), windows 196 (including 196-1 through 196-8), corners or edges 195 (including corner 195-1 in the northwest corner of the building 198, corner 195-2 in the northeast corner of the first room, corner 195-3 in the southwest corner of the first room, corner 195-4 in the southeast corner of the first room, corner 195-5 at the northern edge of the inter-room passage between the first room and a hallway, etc.), furniture 191-193 (*e.g.*, a couch 191; chair 192; table 193; etc.), pictures or paintings or televisions or other hanging objects 194 (such as 194-1 and 194-2) hung on walls, light fixtures (not shown in Figure 1B), various built-in appliances or fixtures or other structural elements (not shown in Figure 1B), etc. The user may also optionally provide a textual or auditory identifier to be associated with an acquisition location, such as "living room" for the room including acquisition locations 210A and/or 210B, while in other embodiments the ICA system may automatically generate such identifiers (*e.g.*, by automatically analyzing images and/or video and/or other recorded information for a building to perform a corresponding automated determination, such as by using machine learning) or the MIGM system may determine such identifiers (*e.g.*, based at least in part on input from ICA and/or MIGM system operator users) or the identifiers may not be used.

After the first acquisition location 210A has been captured, the mobile device 185 and/or camera device(s) 184 may move or be moved to a next acquisition location (such as acquisition location 210B), optionally recording images and/or video and/or other data from the hardware components (*e.g*., from one or more IMUs, from the camera, etc.) during movement between the acquisition locations. At the next acquisition location, the mobile 185 and/or camera device(s) 184 may similarly capture a 360° panorama image and/or other type of image from that acquisition location. This process may repeat for some or all rooms of the building and in some cases external to the building, as illustrated for acquisition locations 210C-210P in this example, with the images from acquisition locations 210A to 210-0 being captured in a single image acquisition session in this example (*e.g.*, in a substantially continuous manner, such as within a total of 5 minutes or 15 minutes), and with the image from acquisition location 210P optionally being acquired at a different time (*e.g.*, from a street adjacent to the building or front yard of the building). The acquired images for each acquisition location may be further analyzed, including in some embodiments to render or otherwise place each panorama image in an equirectangular format, whether at the time of image acquisition or later.

Various details are provided with respect to Figures 1A-1B, but it will be appreciated that the provided details are non-exclusive examples included for illustrative purposes, and other embodiments may be performed in other manners without some or all such details.

Figures 2A-2N illustrate examples of generating and presenting a floor plan for a building using images of the building interior and additional room layout information for rooms of the building, such as for the house 198 and images acquired at acquisition locations 210 discussed in Figure 1B.

In particular, Figure 2A illustrates an example image 250a, such as a perspective image taken in a northeasterly direction from acquisition location 210B in the living room of house 198 of Figure 1B (or a northeasterly facing subset view of a 360-degree panorama image taken from that acquisition location and formatted in a rectilinear manner) - the directional indicator 109a is further displayed in this example to illustrate the northeasterly direction in which the image is taken. In the illustrated example, the displayed image includes built-in elements (*e.g.*, light fixture 130a), furniture (*e.g*., chair 192), two windows 196-1, and a picture 194-1 hanging on the north wall of the living room. No inter-room passages into or out of the living room (*e.g*., doors or other wall openings) are visible in this image. However, multiple room borders are visible in the image 250a, including horizontal borders between a visible portion of the north wall of the living room and the living room's ceiling and floor, horizontal borders between a visible portion of the east wall of the living room and the living room's ceiling and floor, and the vertical border 195-2 between the north and east walls.

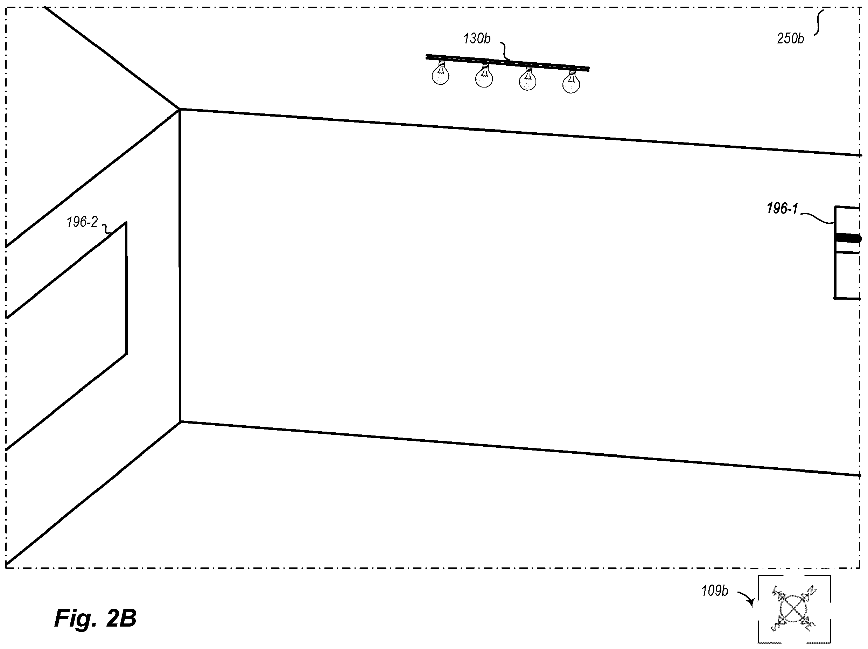

Figure 2B continues the example of Figure 2A, and illustrates an additional perspective image 250b taken in a northwesterly direction from acquisition location 210B in the living room of house 198 of Figure 1B (or a northwesterly facing subset view of a 360-degree panorama image taken from that acquisition location and formatted in a rectilinear manner) - the directional indicator 109b is further displayed to illustrate the northwesterly direction in which the image is taken. In this example image, a small portion of one of the windows 196-1 continues to be visible, along with a portion of window 196-2 and an additional lighting fixture 130b. In addition, horizontal and vertical room borders are visible in image 250b in a manner similar to that of Figure 2A.

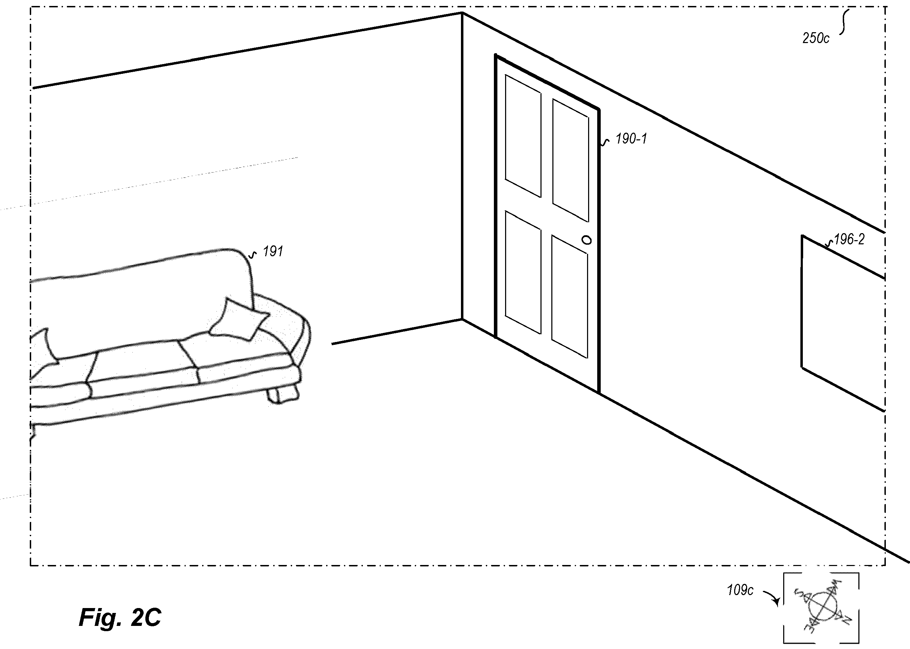

Figure 2C continues the examples of Figures 2A-2B, and illustrates a third perspective image 250c taken in a southwesterly direction in the living room of house 198 of Figure 1B, such as from acquisition location 210B or 210A (or a southwesterly facing subset view of a 360-degree panorama image taken from one of those acquisition locations and formatted in a rectilinear manner) - the directional indicator 109c is further displayed to illustrate the southwesterly direction in which the image is taken. In this example image, a portion of window 196-2 continues to be visible, as is a couch 191 and visual horizontal and vertical room borders in a manner similar to that of Figures 2A and 2B. This example image further illustrates a wall opening passage for the living room, which in this example is a doorway 190-1 (which is identified in Figure 1B as a doorway to the exterior of the house). It will be appreciated that a variety of other perspective images may be taken from acquisition location 210B and/or other acquisition locations and displayed in a similar manner.

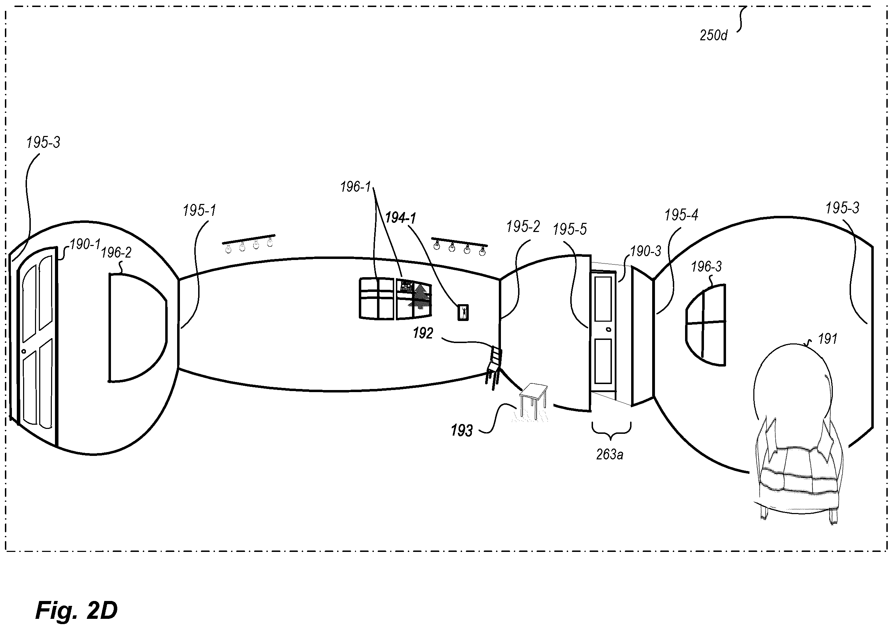

Figure 2D continues the examples of Figures 2A-2C, and illustrates a 360° panorama image 250d (*e.g*., taken from acquisition location 210B), which displays the entire living room in an equirectangular format - since the panorama image does not have a direction in the same manner as the perspective images of Figures 2A-2C, the directional indicator 109 is not displayed in Figure 2D, although a pose for the panorama image may include one or more associated directions (*e.g*., a starting and/or ending direction for the panorama image, such as if acquired via rotation). A portion of the visual data of panorama image 250d corresponds to the first perspective image 250a (shown in approximately the center portion of the image 250d), while the left portion of the image 250d and the far-right portion of the image 250d contain visual data corresponding to those of the perspective images 250b and 250c. This example panorama image 250d includes windows 196-1, 196-2 and 196-3, furniture 191-193, a doorway 190-1, and a non-doorway wall opening 263a to the hallway room (with the opening showing part of a door 190-3 visible in the adjacent hallway). Image 250d further illustrates a variety of room borders in a manner similar to that of the perspective images, but with the horizontal borders being displayed in an increasingly curved manner the farther they are from a horizontal midline of the image - the visible borders include vertical inter-wall borders 195-1 through 195-4, vertical border 195-5 at the left side of the hallway opening, vertical borders at the right side of the hallway opening and the southeast corner of the living room, and horizontal borders between the walls and the floor and between the walls and the ceiling.

Figure 2E continues the examples of Figures 2A-2D, and illustrates information 260e that may be provided by an embodiment of the ABIA system, such as to one or more users who are involved in acquiring images of the building (*e.g.*, images 250a-250d of Figures 2A-2D). In particular, in the example of Figure 2E, the information 260e illustrates an example GUI that contains information corresponding to a first image 250f acquired by a user in a building (*e.g*., corresponding to one of images 250a-250d of Figures 2A-2D), including visual data of the image (*e.g*., a thumbnail copy of the image), and a rough initial room shape estimation 239a of the room containing the acquisition location of the image - the initial room shape estimation may serve as one type of feedback regarding the image, such as to reflect problems with the image if the initial room shape estimation is uncertain or unable to be determined, or appears to be significantly incorrect. In this example, additional information 255e is illustrated for the benefit of the reader but may not be displayed to the user as part of the example GUI, such as to indicate a final room shape 239b that may be determined for the room (*e.g.*, at a later time, such as by the MIGM system), which in this example illustrates the location of windows, doorways and non-doorway wall openings that are detected in the visual data of the image (*e.g.*, other types of structural elements may similarly be identified and indicated, such as stairways, but are not shown in this example for this room shape).

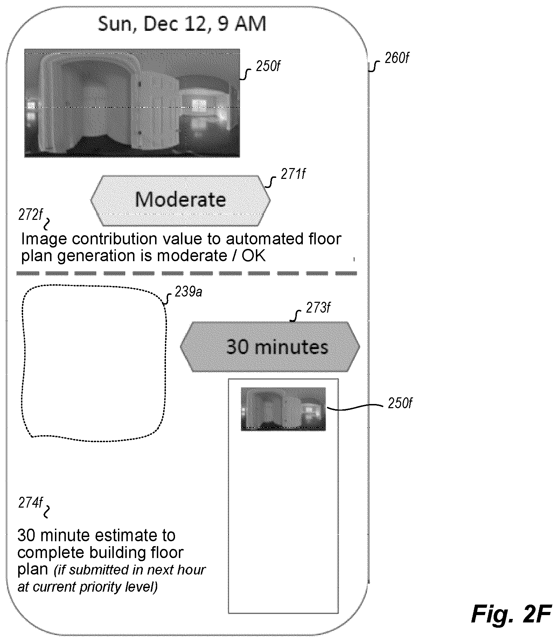

Figure 2F continues the examples of Figures 2A-2E, and illustrates updated information 260f that may be displayed in the example GUI, such as to provide feedback to the user from the ABIA system. In this example, the feedback includes an overall assessment 271f of the value of the image as it contributes to an automated floor plan generation process (*e.g.*, based at least in part on a quality of the visual data of the image, and which in this example is a 'Moderate' rating), textual feedback 272f corresponding to the assessment 271f, a predicted characteristic 273f of the resulting automated floor plan generation process (which in this example is a predicted time until completion of the generation process, with the initial predicted time of 30 minutes), and textual feedback 274f corresponding to the predicted characteristic 273f, which in this example indicates that the predicted time until completion is based on resources that are available over the next hour if the automated floor plan generation process is performed at that time, as well as if a current priority level associated with the automated floor plan generation process is used (*e.g.*, based on a priority level requested by the user or otherwise associated with the user). In addition, a thumbnail image 250f is added to a current image queue or list shown in the lower right portion of the example GUI. It will be appreciated that other types of feedback may be provided in other embodiments and/or that feedback may be provided in other manners in other embodiments, whether in addition to or instead of the illustrated types of feedback and illustrated manners of providing the feedback.

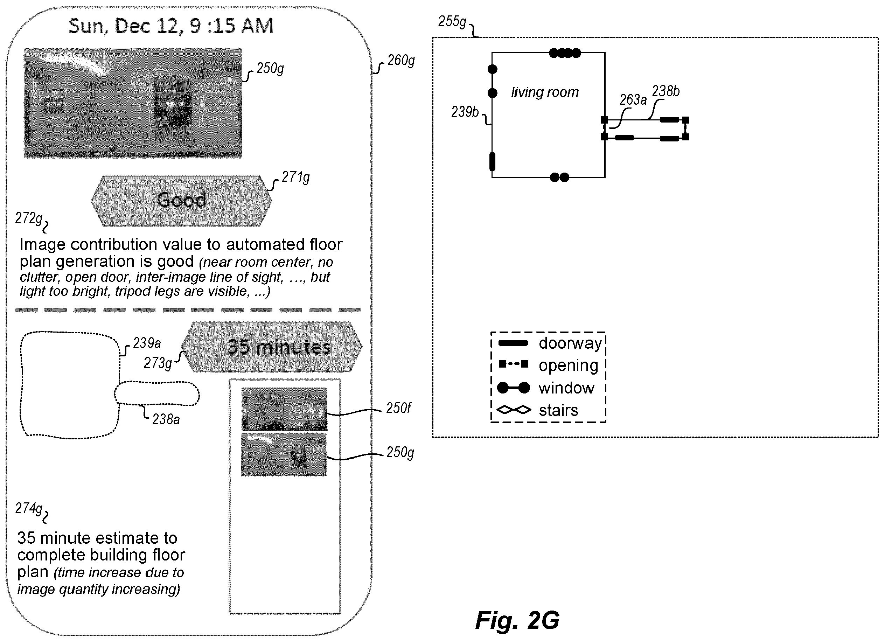

Figure 2G continues the examples of Figures 2A-2F, and illustrates updated information 260g that may be displayed in the example GUI, which in this example corresponds to a next image 250g that is acquired for the building. In this example, the updated GUI includes a corresponding overall assessment 271g for the image 250g, related textual description 272g, updated room shape information that includes an initial estimated room shape 238a for the room that contained the acquisition location for image 250g, and updated predicted characteristic 273g for the resulting automated floor plan generation process, and a corresponding textual feedback 274g. In this example, the overall assessment of the current image is a 'Good' rating, and associated textual description 272g provides information about both positive and negative attributes of the image that correspond to that rating. In addition, the initial additional room shape estimate 238a is shown at a position relative to that of the prior room shape estimate 239a, although such room shape estimate information may be illustrated in other manners. The image queue or list is also updated to include a thumbnail copy of the image 250g, and that predicted characteristic 273g has been changed from a prior 30 minutes to a current 35 minutes, such as to reflect the overall quality of acquired images increasing (*e.g*., to correspond to additional computing time that will be used to complete the automated floor plan generation process). The example of Figure 2G further illustrates example information 255g for the purpose of the reader that may not be displayed in the example GUI, such as to illustrate a final room shape estimate 238b that may be determined for the new room corresponding to image 250g, with the relative positions of the final room shape estimates 239b and 238b illustrating a final layout of the room shapes relative to each other (*e.g*., with the room shape estimate 238b and final layout of the two room shapes determined at a later time, such as by the MIGM system, optionally based in part on a shared common non-doorway wall opening 263a between the two rooms).

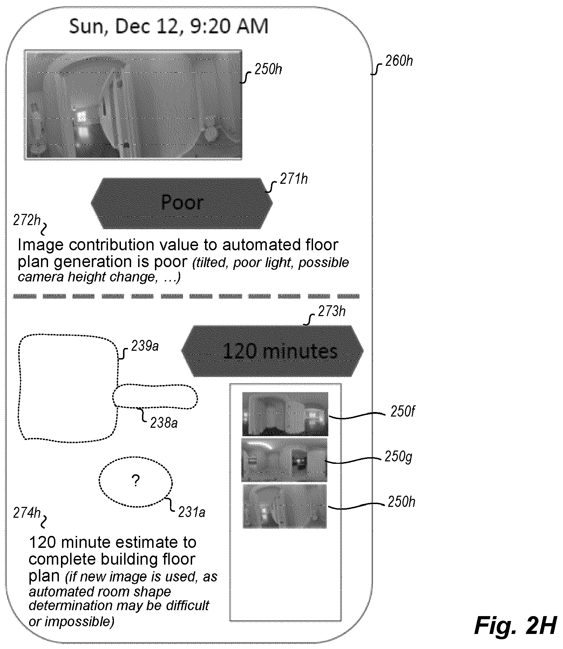

Figure 2H continues the examples of Figures 2A-2G, and illustrates updated information 260h that may be displayed in the example GUI, which in this example corresponds to a next image 250h that is acquired for the building. In this example, the image 250h is assessed to have an overall 'Poor' quality rating, as reflected in the assessment 271h, and the resulting estimated room shape 231a for the room corresponding to the image indicates that the room shape cannot be determined from the image due to problems in the image. The textual feedback description 272h indicate some of the problems with the image 250h, and may in some embodiments and situations include corresponding instructions to the user and/or to the image acquisition device (*e.g*., to recapture the image, optionally after correcting one or more of the problems), although such instructions are not illustrated in this example. The updated predicted characteristics 273h for the automated floor plan generation process has significantly increased from 35 minutes of Figure 2G to 120 minutes, with the associated textual description 274h indicating that the increase in time corresponds to an automated room shape determination based on the image being difficult or impossible, such that manual input from one or more operator users may be needed to determine the corresponding room shape 231a if the current image 250h is retained and used (rather than being replaced by one or more other images without the problems of image 250h). The two or list of images is currently updated to illustrate a thumbnail copy of the image 250h, but that thumbnail copy may not be subsequently retained if the image 250h is not retained for use in the automated floor plan generation process (*e.g.*, based on the user providing an indication to discard the current image, such as by using a corresponding user-selectable control in the GUI, not shown; based on the user capturing a new replacement image from the same or substantially same acquisition location; etc.).

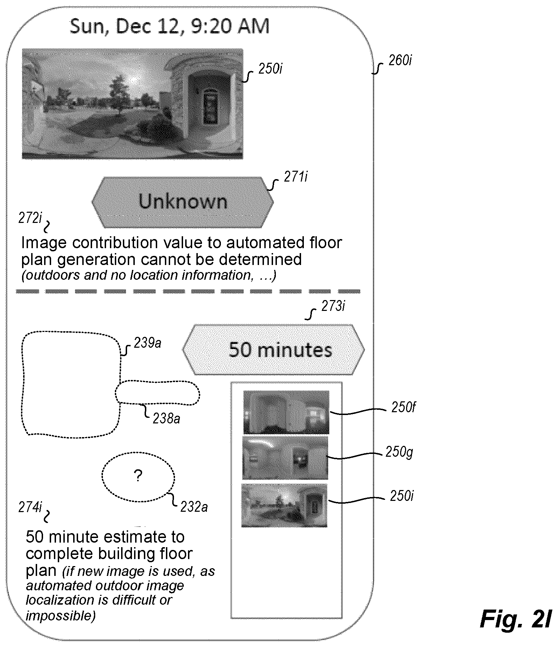

Figure 2I continues the examples of Figures 2A-2H, and illustrates updated information 260i that may be displayed in the example GUI, which in this example corresponds to a next image 250i that is acquired for the building from an external location. In this example, the image queue or list includes a thumbnail copy of the new image 250i but not the prior image 250h, such as to indicate that the prior image 250h is not retained for use in the automated floor plan generation process due to its problems (*e.g*., is to be replaced by a new replacement image, not shown). However, the example image 250i had other types of problems, as described in the textual description 272i and reflected in the current assessment 271i with an 'Unknown' rating, which in this example corresponds to the image being captured outdoors without location information that would allow its position to be determined relative to other images 250f and 250g, and without surrounding structures to enable a room shape estimate 232a for the exterior area to be determined. The updated predicted characteristics 273i for the automated floor plan generation process has increased from 35 minutes of Figure 2G to 50 minutes, with the associated textual description 274i indicating that the increase in time corresponds to an automated 'localization' determination of the acquisition pose (location and orientation) of the image 250i being difficult or impossible to perform in an automated manner, such that manual input from one or more operator users may be needed to determine the corresponding localization information and optionally corresponding room shape 232a if the current image 250i is retained and used.

Figure 2J continues the examples of Figures 2A-2I, and illustrates other information 260j that may be displayed in the example GUI, which in this example corresponds to an initial information that may be displayed to a user before the image acquisition process begins for the building (*e.g*., before the first image 250e is acquired). In this example, the information in the example GUI corresponds to initial estimates that are determined by the ABIA system before the image acquisition process begins, such as to reflect an initial estimate of how long the image acquisition process will take (in this example, 20 minutes) and/or an initial estimate of how long the automated floor plan generation process will take (in this example, 25 minutes). Such estimates may be based on a variety of factors, with examples of such factors included in the illustrated information that correspond to information about the building (*e.g*., square footage; complexity based on home structure, such as estimated from satellite views, street view, and number and distribution of rooms; number of floors and rooms; year of build, builder information; similar properties based on geographic or builder information; etc.), previous performance numbers for similar buildings, the user involved in the image acquisition process (*e.g.*, historical performance of the user), available resources for use during the generation process (*e.g.*, server availability, GPU/CPU availability, current backlog of requests for generation processes for other buildings and complexity of those backlog activities, human users available to provide manual assistance, etc.), other factors affecting the generation process (*e.g*., a selected choice of one or more from multiple types of generation process functionality and/or priorities, if available), etc. In addition, the illustrated information indicates that further assistance may be provided to the user, such as to indicate a different time at which the generation process may be performed more quickly or in another advantageous manner (*e.g*., to use less resources), or to otherwise provide other types of assistive information to the user. In other embodiments, no such initial information may be provided, or the initial information that is provided may be of other types, whether in addition to or instead of the illustrated types of information.

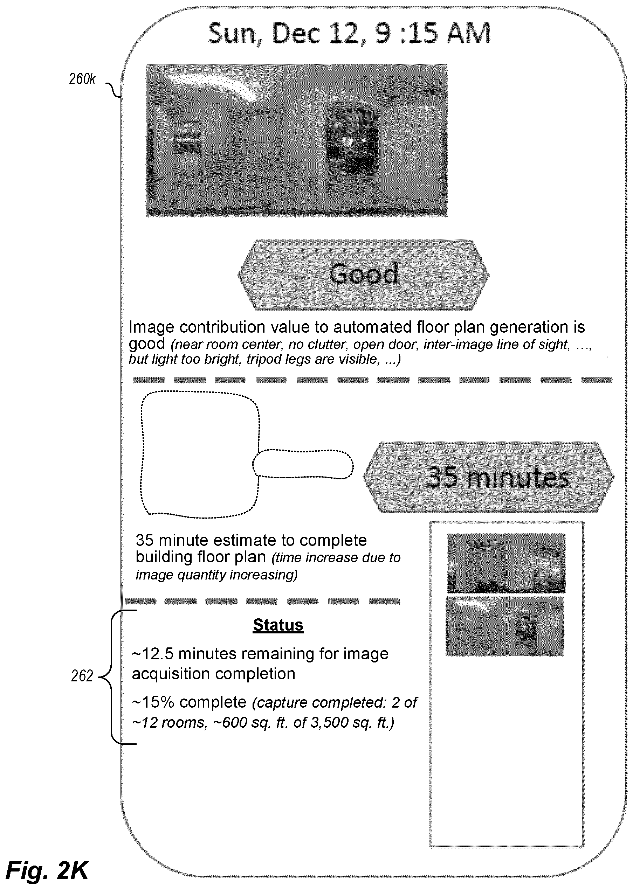

Figure 2K continues the examples of Figures 2A-2J, and illustrates other information 260k that may be displayed in the example GUI, which in this example includes additional status information 262 that may be provided to the user throughout the various GUI displays of the image acquisition process (in this example shown as a modification to the information 260g of Figure 2G). In particular, the example status information 262 of this example includes information about a remaining estimated amount of time to complete the image acquisition process, and information about a percentage of completeness or work remaining with respect to the image capture. In other embodiments, such status information may not be provided, or other status information of different types may be provided, whether in addition to or instead of the illustrated types of status information.

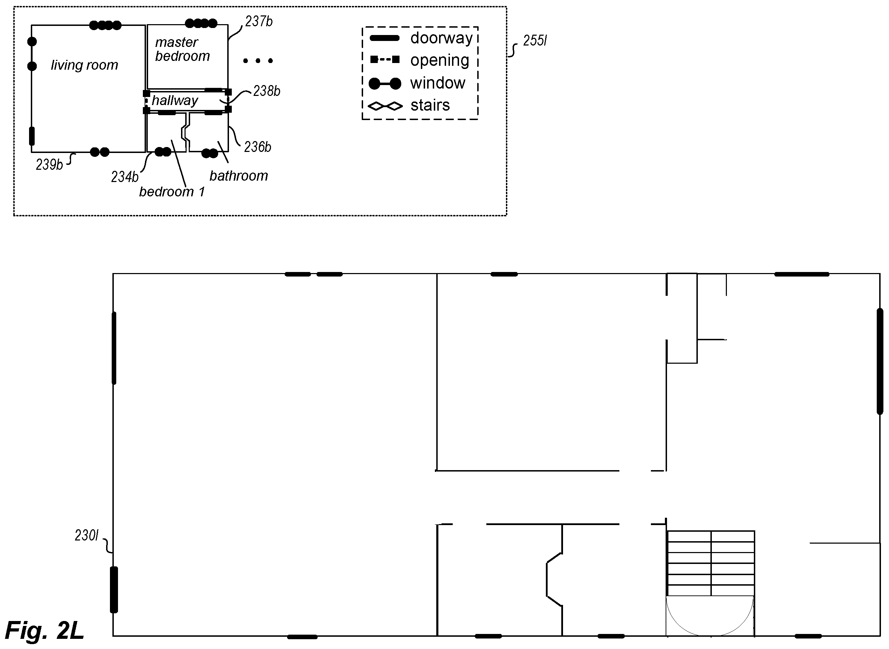

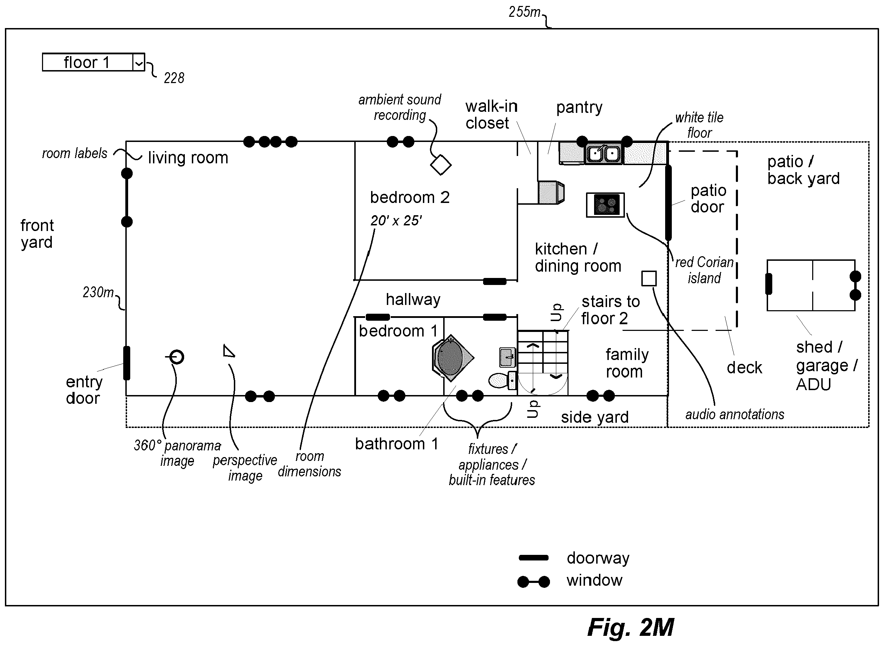

Figure 2L continues the examples of Figures 2A-2K, and illustrates updated information 2551 corresponding to the ongoing determination of final room shapes and layouts as additional images are acquired and analyzed, resulting in a final room shape/layout 230l for the first floor of the building after all of the images have been captured and an analyzed for that first floor. The final room shape/layout 2301 may in some embodiments be used as a 2D floor plan for the first floor of the building, while in other embodiments the 2D floor plan may be generated and provided in other manners, such as that illustrated with respect to Figure 2M.

It will be appreciated that the types of image assessments and determinations of corresponding mapping information generation process characteristics discussed with respect to Figures 2E-2L and elsewhere herein may be performed in various manners in various embodiments. In one example non-exclusive embodiment, the image assessments and characteristics determinations are performed using a combination of computer vision analyses, machine learning algorithms, and optionally user-supplied input. For example, as a user captures images of the house or other building, both image quality/contribution measures and resulting generation process characteristics (*e.g.*, time until completion) are determined and updated. The updated characteristics and quality/contribution assessments may be presented as feedback to a user through a suitable UI, such as to augment the user experience and/or improve the results - for example, one possibility is to overlay a currently acquired image on a reconstructed replica of the floor plan created from all the images acquired so far, such as using initial rough room shape estimates as determined on a mobile image acquisition computing device that is capturing the images, and with such a reconstructed floor plan replica able to serve as both a UI outcome as well as an input for measuring of the quality and time until completion. In addition, such feedback provides the user with the ability during and/or after the image acquisition process to improve characteristics of the mapping information generation process (*e.g*., time until completion, quality, etc.), such as by modifying, recapturing, or adding additional information (such as information correcting the location, classification, and other annotations of images).

As non-exclusive examples of assessing image quality/contribution for this example embodiment, the ABIA system may determine one or both of individual image quality and image contribution to floor plan generation. With respect to individual image quality, an individual image may, for example, be analyzed using computer vision and machine learning algorithms to determine one or more of the following non-exclusive list of quality-related attributes: lighting in the room; flash or photo artifacts; zoom/motion blur in image; presence of distracting elements (*e.g.*, clutter, human, pets, large objects, camera tripod, camera accessories, etc.); open/closed nature of doors and windows; closeness to walls and furniture; varying height or other parameters of the capturing camera equipment (*e.g.*, zoom level, aperture, etc.); an image being captured in a different orientation than expected (horizontal vs vertical); etc. With respect to image contribution to floor plan generation, the overall collection of acquired images may be treated as a joint input to a fully automated floor plan generation process and/or an automated floor plan generation process that solicits and uses human input, with individual images that make the collection easier to analyze (*e.g.*, easier to process in a fully automated generation process) being ranked higher in quality/contribution assessment. With respect to individual image contribution to floor plan generation, an individual image may, for example, be analyzed using computer vision and machine learning algorithms to determine one or more of the following non-exclusive list of contribution-related attributes: distance of image's acquisition location to other acquired images in the collection; uncertainty or inaccuracy in the estimated room shape from the current image; presence of unexpected room structures when current image is included (*e.g.*, colliding walls, misaligned doors and walls, missing doors and windows, etc.); inability to estimate the location of the image in the reconstructed floor plan (*e.g.*, due to failure of computer vision or other sources of location information, such as based on one or more of IMU data, GPS data, etc.); unexpected change in estimated floor plan by inclusion of current image (*e.g.*, an image appears to make the floor plan much longer than the expected dimensions of the home); etc. Along with individual image quality assessments (*e.g.*, good/ok/bad/unknown) and generation process characteristics (*e.g.*, time for completion), the ABIA system is able to generate and provide detailed feedback behind the reasons for the estimated values.

As non-exclusive examples of assessing one or more floor plan generation process characteristics (*e.g.,* time until completion) and/or corresponding characteristics for a generation process for other types of mapping information in this example embodiment, the ABIA system may evaluate the impact of images as they are captured on one or more such generation process characteristics. For example, an image that increases automation, reduces uncertainty, and presents wider coverage of the home may lower a time-until-completion characteristic, while poorly captured images or images that otherwise have poor visual data quality may increase such a characteristic (*e.g*., due to additional automated processing that is required, due to using manual input, etc.). Such image-related contribution assessments may further be combined with other types of information in at least some embodiments to assess a generation process time-until-completion characteristic and/or other types of generation process characteristics, such as information about the user participating in the image acquisition (*e.g*., using information about the user history), about the building, about the resources available for use in the automated generation process, etc. - furthermore, at least some types of information may become available at different times or may change during the image acquisition process (*e.g*., about available resources), such that the ABIA system may use the currently available information to generate and provide a best estimate at any given time. With respect to assessing an image's contribution to a generation process characteristic, the ABIA system may determine and use one or more of the previously identified image quality-related attributes and/or one or more attributes of an imaged room (*e.g*., size, type/nature/classification, complexity of the shape, etc.). With respect to assessing the contribution of non-image factors to a generation process characteristic, the ABIA system may determine and use one or more of the previously identified contribution-related attributes and/or one or more of the following non-exclusive attributes: details of the building and/or its surrounding property (*e.g*., size, shape, complexity, number of floors, types of rooms, furnished/unfurnished, etc.); details about other related buildings/properties (*e.g.*, generation process characteristics for similar buildings/properties, such as built by the same or similar builders, in the same or nearby communities, built in at the same or similar times, etc.); details about resources available for the generation process, such as based on a current and/or predicted state of an automated pipeline to implement such an automated generation process for multiple buildings/properties (whether fully automated or using manual assistance), and based on factors such as server capacity and/or other compute resources (*e.g*., availability of CPUs and GPUs), state of current in-production machine learning models used in the pipeline, availability of human user resources to provide manual assistance, quantity and/or complexity of other current and/or expected generation processes in the pipeline, priority of the generation process (*e.g.*, relative to other current and/or expected generation processes in the pipeline), etc.); details about the one or more image acquisition devices used to acquire the images (*e.g.*, camera characteristics, device age, etc.); other factors (*e.g.*, agreement between an automatically generated floor plan and expected results from other sources); details about one or more users involved in acquiring the images (*e.g.*, the user's historical performance with respect to image quality, with respect to speed in image acquisition, with respect to actual characteristics of generation processes based on the user's images, with respect to historical differences between predicted and actual characteristics of generation processes based on the user's images, with respect to preferences or instructions that affect generation process characteristics such as relative importance of generation process speed versus costs or other factors, etc.); etc. Information for use in assessing generation process characteristics other than from the images themselves may be obtained from various sources in various embodiments, such as obtained or estimated from publicly available records (*e.g.*, MLS, county property records, listing details, etc.), determined through image analysis (*e.g.*, applying computer vision algorithms to satellite imagery, other overhead images such as from drones or airplanes or other overhead locations, street-view imagery, etc.), or otherwise obtained.

As a non-exclusive example of processing performed to assess image quality and contribution in this example embodiment, computer vision and/or machine learning algorithms may be used to predict attributes from input images. For example, for each attribute, a training set of thousands of images may be labeled, and a corresponding machine learning model (*e.g.*, using a neural network, based on classical vision, etc.) is then trained to predict these attributes using the training set (*e.g.*, using supervised learning), with the resulting trained machine learning model then applied to predict these attributes on new images acquired during an image acquisition process for a building. As part of doing so, the presence or absence of each such attribute determines the quality of the image with respect to that attribute, and with aggregating of the quality estimates for multiple such attributes performed to determine an overall quality classification assessment for the image, and corresponding feedback messages may be automatically generated and/or selected from a group of manually specified messages. As part of selecting the attributes for which to train and use corresponding machine learning models, the techniques may in some embodiments use other machine learning models trained to determine such attributes implicitly from a data set of images (*e.g.*, using unsupervised learning, without any human labeling of the quality or attributes of the image), such as to use automated and/or human annotation of the images to determine the quality of each image - for example, using images previously annotated in the automated pipeline and/or manually annotated, a subset of the images may be identified using defined criteria (*e.g.*, for positive quality images, manual annotation took less than X seconds and/or a final outcome of manual annotation deviated from the automatic annotation by less than Y%; for negative quality images, manual annotation took at least X seconds and/or a final outcome of manual annotation deviated from the automatic annotation by at least Y%; etc.), and then other machine learning model(s) may be trained using them (*e.g.*, until the model's loss function is within acceptable threshold or has stopped improving, and for each input image in training set, predict positive or negative label for image, determine loss or error from ground truth positive or negative label, compute binary cross entropy loss function over all images in training set, and update the weights of the model to minimize the loss).

As a non-exclusive example of processing performed to assess one or more mapping information generation process characteristics (*e.g.*, time until completion, cost until completion, etc.) in this example embodiment, a regression model (*e.g.*, implemented using a neural network, probabilistic model, random tree/forest, etc.) may be used for predicting the characteristic(s). For example, for prior image acquisition processes and corresponding acquired images, they may be filtered based on the corresponding actual values for the one or more generation process characteristic(s) resulting from those images and image acquisition processes to create a training set. Next, one or more machine learning model(s) may be trained using them (*e.g*., until the model's loss function is within acceptable threshold or has stopped improving, and for each input image and/or image acquisition process in training set, predict the time-until-completion value and/or other characteristic value, compute a loss function over all examples in training set, and update the weights of the model to minimize the loss).

In addition, in some embodiments, a user may be provided with choices that affect how the mapping information generation process is performed and optionally the results of the process, such as to obtain a generated floor plan more quickly but with lower quality (*e.g*., more uncertainty as to room shapes and/or sizes), or to otherwise have tradeoffs with respect to one or more metrics (*e.g*., time, quality, monetary cost, etc.). As part of doing so, a user may be able to select different times for performing the mapping information generation process (*e.g*., to do so at off-peak hours in order to receive higher quality results for a given amount of processing time or to otherwise reduce costs or time or increase quality or other characteristics, such as for particular times identified by the ABIA system), to modify the image acquisition process and/or to provide additional data (*e.g*., manually supplied information by the image acquisition user, such as information about particular acquisition locations associated with particular acquired images) to improve the generation process (*e.g.*, reduce time and/or cost, increase quality of results, etc.), or to otherwise affect how the generation process is performed (*e.g.*, to select from multiple available types of functionality, such as to generate a 2D floor plan and/or a 3D computer model floor plan and/or a virtual tour of linked images, etc.).

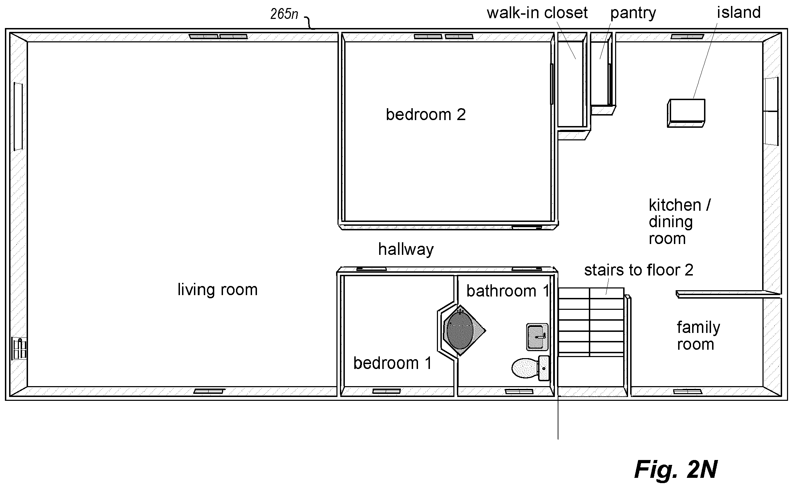

Figures 2M-2N continue the examples of Figure 2A-2L, and illustrate further mapping information that may be generated from the types of analyses discussed herein. In particular, after all of the room shape interconnection and other layout information has been determined for the house, whether automatically by the MIGM system and/or by using information supplied by one or more MIGM system operator users, the final results may be used to generate a 2D floor plan of the house, optionally after final optimizations have been performed and visual aspects of the final floor plan have been added - such final optimizations may include, for example, one or more of ensuring consistent visual aspects (*e.g*., line widths, colors, text styles, etc.), placing textual room labels at preferred locations on the final floor plan, adding missing spaces such as small closets or other additional areas not included on the defined room shape layouts (*e.g.*, areas that did not have any images taken from within them, resulting in empty spaces within an exterior of the building that are not identified in the defined room shape layouts), merging multiple overlapping and/or adjacent walls, correcting any geometric anomalies, etc. In at least some embodiments, the described techniques may include performing at least some such updates in an automated manner, and optionally providing corresponding GUI tools for one or more users to make final manual adjustments (*e.g*., GUI tools similar to those of a drawing or painting program) to a floor plan for the house that is generated. In the example of Figure 2M, an example final 2D floor plan 230m is illustrated that may be constructed based on the described techniques, which in this example includes walls and indications of doorways and windows, and such as may be presented to a system operator user and/or end user in a GUI 255m, and with various types of information being added to the combination of interconnected room shapes - it will be appreciated that a 3D or 2.5D model floor plan showing wall height information may be similarly generated in some embodiments, whether in addition to or instead of such a 2D floor plan, such as 3D floor plan 265n of Figure N. In this example of Figure 2M, room labels have been added to some or all rooms (*e.g*., "living room" for the living room), room dimensions have been added for some or all rooms, visual indications of fixtures or appliances or other built-in features have been added for some or all rooms, visual indications of positions of additional types of associated and linked information have been added (*e.g*., of panorama images and/or perspective images that an end user may select for further display, of audio annotations and/or sound recordings that an end user may select for further presentation, etc.), visual indications of doorways and windows may be shown, etc. - in addition, in at least some embodiments and situations, some or all such types of information may be provided by one or more MIGM system operator users (*e.g.*, to receive textual room labels from those users). In addition, in this example a user-selectable control 228 is added to the GUI to indicate a current floor that is displayed for the floor plan, and to allow the user to select a different floor to be displayed - in some embodiments, a change in floors or other levels may also be made directly from the floor plan (such as via selection of a connecting passage, such as the stairs to floor 2 in the illustrated floor plan), and in some embodiments information for multiple floors (*e.g*., all floors) will be displayed simultaneously (whether as separate sub-floor plans for separate floors, or instead by integrating the room connection information for all rooms and floors into a single floor plan that is shown together at once). It will be appreciated that a variety of other types of information may be added in some embodiments, that some of the illustrated types of information may not be provided in some embodiments, and that visual indications of and user selections of linked and associated information may be displayed and selected in other manners in other embodiments. Figure 2N illustrates additional information 265n that may be generated from the automated analysis techniques disclosed herein and displayed (*e.g.*, in a GUI similar to that of Figure 2M), which in this example is a 2.5D or 3D model floor plan of the house. Such a model 265n may be additional mapping-related information that is generated based on the floor plan 230m, with additional information about height shown in order to illustrate visual locations in walls of features such as windows and doors, or instead by combining final estimated room shapes that are 3D shapes. While not illustrated in Figure 2N, additional information may be added to the displayed walls in some embodiments, such as from acquired images (*e.g.*, to render and illustrate actual paint, wallpaper or other surfaces from the house on the rendered model 265n), and/or may otherwise be used to add specified colors, textures or other visual information to walls and/or other surfaces, and/or other types of additional information shown in Figure 2M (*e.g.*, information about exterior areas and/or accessory structures) may be shown using such a rendered model.

Various details have been provided with respect to Figures 2A-2N, but it will be appreciated that the provided details are non-exclusive examples included for illustrative purposes, and other embodiments may be performed in other manners without some or all such details.

In addition, a variety of additional automated functionality (and in at least some embodiments, associated GUI functionality for use by one or more system operator users) may be provided by and/or used in at least some embodiments. As one example, in some embodiments functionality may be provided to combine multiple panorama images that are taken in a single room into a single panorama image, such as by localizing information for one of the panorama images into the space of the other panorama image - for example, both panorama images may be displayed to a user who selects one or more common points in both images (*e.g*., a common plane with infinite points in both images), with the MIGM system determining the corresponding locations of the visual information of the two panorama images based on the indicated common point(s). After such a combination panorama image is created, it may be further used in a similar manner to that of other panorama images, as discussed in greater detail elsewhere herein. In addition, in some embodiments one or more additional supplemental panorama images are used in combination with a single primary panorama image for each room, such as to generate a supplemental panorama image at the location of each of one or more inter-room connections in order to assist in determining the connection between those rooms (*e.g*., alignment and other layout of the room shapes of the rooms), such as by using information in the supplemental panorama image to match to corresponding features in the panorama images for each of the connecting rooms. Moreover, in some embodiments additional functionality may be provided (*e.g.*, by the MIGM system) to perform a global optimization of a generated floor plan, such as to identify final alignments of walls and other room shape information. In addition, in some embodiments additional functionality may be provided (*e.g*., by the MIGM system) to refine transformations of room shapes, such as by providing an optimization that uses alignment of line segments and a top-down view or by using direct image overlaps (*e.g.*, via rendering). Moreover, in some embodiments additional functionality may be provided (*e.g.,* by the MIGM system) to perform or assist with a selection of a first room shape to begin generation of a floor plan, such as based on an automated analysis of information about that room (*e.g*., relative to that of other rooms of the building), and/or based on information supplied by a system operator user (*e.g.*, after information about some or all room shapes is displayed or otherwise provided to the user) - as one example, a room may be selected to be used as a starting room based on one or more factors, such as having the most inter-room wall openings, the least inter-room wall openings, a wall opening corresponding to an exterior door (*e.g*., the entry to the building), the order of panorama image capture (*e.g.*, to use the room corresponding to the first panorama image capture or the last panorama image captured), etc.

Furthermore, in some embodiments additional functionality may be provided (*e.g.,* by the MIGM system) to align or otherwise connect multiple floors or other levels of the building, such as via connecting stairways or other connecting passages. Such additional functionality may include, for example, aligning the multiple floors of a house into a single coordinate system so that they can all be rendered as a 3D model (*e.g*., in a rendering system), and/or aligning the multiple floors of a house in 2D so that they can be overlaid in a top-down orthographic projection (*e.g*., in a CAD system or in architectural blueprints). As one non-exclusive example, one way to implement connections between rooms on two separate floors is to use panorama images that show the stairway connecting the two floors, such as a panorama image at one or both of the bottom and top of the stairs (*e.g*., for a straight stairway that directly connects the floors, without any stair landing), and to interconnect the wall openings of the rooms at the top and bottom of the stairs in a manner similar to other wall opening connections (such as by including a horizontal distance between the two wall openings corresponding to a measured or estimated length of the stairs, and optionally including vertical information between the two wall openings if available), and with the sub-floor plans for two such floors being rotated in a consistent manner and at corresponding positions in 3D space. Estimates of the height difference and horizontal distance between two such wall openings at the ends of a stairway may be determined, for example, if a height of a stairway step is known (*e.g*., the height of a riser and the tread above it) and/or if a panorama image is available in which both the stairway foot and head ends are visible (*e.g*., from the top or bottom of a straight stairway; from each stairway landing of a non-straight stairway, such as by treating each such landing as an 'intermediate' floor that is connected with the other floors in a manner analogous to that of connecting two floors for a straight stairway; etc.) that enables determination of horizon line(s) in the panorama image corresponding to the stairway foot and/or head. In some embodiments and situations, a height and/or depth of a step could be measured during panorama image capture, whether manually or automatically using an object of known size on one of the steps. In addition, the quantity of steps may be automatically determined using image processing in some embodiments, with that information combined with step depth information to determine a horizontal length of the stairway (optionally accounting for the nosing/overhang of the stair tread over the riser) and/or with step height information to determine a vertical height of the stairway. In this manner, such embodiments may perform the connection of rooms on two floors using relatively sparse geometric features with clear semantic meanings (*e.g.*, the lines in one or more panorama images representing the foot and head of a stairway) in a minimal number of captured panorama images, rather than using dense data with numerous panorama images (*e.g*., to provide dense visual connection information) and/or other dense measurements taken along a stairway.

In addition, in at least some embodiments additional information may be used as part of generating a floor plan for a building that is obtained outside of the building, such as one or more panorama images acquired outside of the building (*e.g*., in which some or all of the building is visible), one or more panorama images acquired of outbuildings or other structures on the same property, satellite and/or drone images from overhead, images from a street adjacent to the building, information from property records or other sources about dimensions of the exterior of the building, etc. As one example, one or more exterior panorama images may be used to identify a shape of an exterior wall of the building, the quantity and/or locations of one or more windows in the exterior wall, identification of one or more floors of the building that are visible from that exterior, etc., such as from an automated analysis of the panorama images and/or based on manual annotations of the panorama images by one or more MIGM system operator users, and with such information subsequently used to eliminate/select and/or to rank possible room connections according to how they fit with the information acquired from the exterior panorama image(s). As another example, one or more exterior panorama images may be treated as being part of one or more exterior rooms that surround or are otherwise associated with the building, with the exterior rooms being modeled (*e.g*., with room shapes) and connected to and used with other interior rooms of the building in a floor plan and/or in other manners. It will be appreciated that a variety of other types of functionality may similarly be provided in at least some embodiments.

Figure 3 is a block diagram illustrating an embodiment of one or more server computing systems 300 executing an implementation of an ABIA system 350, one or more server computing systems 380 executing an implementation of an MIGM system 389, one or more mobile image acquisition computing devices 360 executing an implementation of an ICA system 368, and other client computing devices 390 - the server computing systems 300 and 380 and computing devices 360 and 390 (and ABIA and/or MIGM and/or ICA systems) may be implemented using a plurality of hardware components that form electronic circuits suitable for and configured to, when in combined operation, perform at least some of the techniques described herein. One or more additional separate camera devices may similarly be used, such as to acquire building images in addition to or instead of the mobile device(s) 360, but are not illustrated in this example. In the illustrated embodiment, each server computing system 300 includes one or more hardware central processing units ("CPUs") or other hardware processors 305, various input/output ("I/O") components 310, storage 320, and memory 330, with the illustrated I/O components including a display 311, a network connection 312, a computer-readable media drive 313, and other I/O devices 315 (*e.g*., keyboards, mice or other pointing devices, microphones, speakers, GPS receivers, etc.). Each server computing system 380 and computing devices 360 and 390 may have similar components, although only some such components (*e.g*., one or more hardware processors 381, memory 387, storage 385 and I/O components 382 of server computing system 380; one or more hardware processors 361, memory 367, storage 365 and I/O components 362 of mobile device 360; etc.) are illustrated for the sake of brevity.

The server computing system(s) 300 and executing ABIA system 350, and server computing system(s) 380 and executing MIGM system 389, and mobile computing device(s) 360 and executing ICA system 368, and other devices such as client devices 390 (*e.g*., used by system operator users of the ABIA and/or MIGM and/or ICA systems to interact with those respective systems; used by end users to view floor plans, and optionally associated images and/or other related information; etc.) and/or optional other navigable devices 395 (*e.g*., for use by semi-autonomous or fully autonomous vehicles or other devices) may communicate with each other and with other computing systems and devices in this illustrated embodiment via one or more networks 399 (*e.g.*, the Internet, one or more cellular telephone networks, etc.). In other embodiments, some of the described functionality may be combined in less computing systems, such as to combine the ABIA system 350 and the ICA system 368 in a single system or device, to combine the ABIA system 350 and the MIGM system 389 in a single system or device, to combine the MIGM system 389 and the ICA system 368 in a single system or device, to combine the ABIA system 350 and the ICA system 368 and the MIGM system 389 in a single system or device, etc.

In the illustrated embodiment, an embodiment of the ABIA system 350 executes in memory 330 of the server computing system(s) 300 in order to perform at least some of the described techniques, such as by using the processor(s) 305 to execute software instructions of the system 350 in a manner that configures the processor(s) 305 and computing system 300 to perform automated operations that implement those described techniques. The illustrated embodiment of the ABIA system may include one or more components, not shown, to each perform portions of the functionality of the ABIA system (including to optionally include the ICA system 368 and/or the MIGM system 389), and the memory may further optionally execute one or more other programs 335 (*e.g.*, the ICA system 368 and/or the MIGM system 389, such as instead of or in addition to the MIGM system 389 on the server computing system(s) 380 and/or the ICA system 368 on the mobile device(s) 360). The ABIA system 350 may further, during its operation, store and/or retrieve various types of data on storage 320 (*e.g*., in one or more databases or other data structures), such as one or more of the following: acquired image information 324 (*e.g.*, for 360° panorama images), such as from ICA system 368 (*e.g*., for analysis by the MIGM system to produce room layout information and/or otherwise assist in generating floor plans; for analysis by the ABIA system to assess image attributes such as quality and/or contribution to the floor plan generation process and to determine initial estimated room shape information; to provide to users of client computing devices 390 for display; etc.); generated or received information 325 about room shapes and layouts for rooms of one or more buildings (*e.g*., room shapes and locations of doors and windows and other wall openings in walls of the rooms); generated floor plans and other associated mapping information 326 for one or more buildings (*e.g*., generated and saved 2.5D and/or 3D models, building and room dimensions for use with associated floor plans, additional images and/or annotation information, etc.); information 327 about assessed image attributes and associated assessed generation process characteristics; information 328 about instructions or other feedback provided to users and/or devices participating in the image acquisition process; optionally various types of user information 322 (*e.g.*, about users participating in the image acquisition process, such as historical results, user attributes, user preferences and or supplied instructions regarding performing the generation process, associated priority information for use in the generation process, etc.); and/or various types of additional optional information 329 (*e.g.*, various information related to presentation or other use of one or more building interiors or other environments captured by an ICA system and/or modeled by the MIGM system).

In addition, an embodiment of the ICA system 368 executes in memory 367 of the mobile image acquisition computing device(s) 360 in the illustrated embodiment in order to perform some of the described techniques, such as by using the processor(s) 361 to execute software instructions of the system 368 in a manner that configures the processor(s) 361 and computing device 360 to perform automated operations that implement those described techniques. The illustrated embodiment of the ICA system may include one or more components, not shown, to each perform portions of the functionality of the ICA system, and the memory may further optionally execute one or more other programs (not shown). The ICA system 368 may further, during its operation, store and/or retrieve various types of data on storage 385 (*e.g*., in one or more databases or other data structures), such as information 386 about acquired images and optionally associated acquisition metadata, and optionally other types of information that are not shown in this example (*e.g*., about ICA system operator users, additional images and/or annotation information, dimension/size information for one or more images, etc.).

Furthermore, an embodiment of the MIGM system 389 executes in memory 387 of the server computing system(s) 380 in the illustrated embodiment in order to perform some of the described techniques, such as by using the processor(s) 381 to execute software instructions of the system 389 in a manner that configures the processor(s) 381 and computing system 380 to perform automated operations that implement those described techniques. The illustrated embodiment of the MIGM system may include one or more components, not shown, to each perform portions of the functionality of the MIGM system, and the memory may further optionally execute one or more other programs (not shown). The MIGM system 389 may further, during its operation, store and/or retrieve various types of data on storage 385 (*e.g*., in one or more databases or other data structures), such as information 386 about generated floor plans and/or other generated building mapping information, and optionally other types of information that are not shown in this example (*e.g*., about MIGM system operator users, etc.).

Some or all of the user client computing devices 390 (*e.g.*, mobile devices), mobile image acquisition devices 360, optional other navigable devices 395 and other computing systems (not shown) may similarly include some or all of the same types of components illustrated for server computing system 300. As one non-limiting example, the mobile image acquisition devices 360 are each shown to include one or more hardware CPU(s) 361, I/O components 362, storage 365, and memory 367, with one or more client applications 368 (*e.g*., an application specific to the ABIA system and/or MIGM system and/or ICA system; a browser, not shown; optional other executing programs, not shown; etc.) executing within memory 367, such as to participate in communication with the ABIA system 350, MIGM system 389 and/or other computing systems - the devices 360 each further include one or more imaging systems 364 and IMU hardware sensors 369 and optionally other components (*e.g.*, a lighting system, a depth-sensing system, location sensors, etc.), such as for use in acquisition of images and associated movement data of the device 360. While particular components are not illustrated for the other navigable devices 395 or other computing systems 390, it will be appreciated that they may include similar and/or additional components.

It will also be appreciated that computing systems 300 and 380 and computing devices 360 and the other systems and devices included within Figure 3 are merely illustrative and are not intended to limit the scope of the present invention. The systems and/or devices may instead each include multiple interacting computing systems or devices, and may be connected to other devices that are not specifically illustrated, including via Bluetooth communication or other direct communication, through one or more networks such as the Internet, via the Web, or via one or more private networks (*e.g*., mobile communication networks, etc.). More generally, a device or other computing system may comprise any combination of hardware that may interact and perform the described types of functionality, optionally when programmed or otherwise configured with particular software instructions and/or data structures, including without limitation desktop or other computers (*e.g.*, tablets, slates, etc.), database servers, network storage devices and other network devices, smart phones and other cell phones, consumer electronics, wearable devices, digital music player devices, handheld gaming devices, PDAs, wireless phones, Internet appliances, and various other consumer products that include appropriate communication capabilities. In addition, the functionality provided by the illustrated ABIA system 350 and/or ICA system 368 and/or MIGM system 389 may in some embodiments be distributed in various components, some of the described functionality of the ABIA system 350 and/or ICA system 368 and/or MIGM system 389 may not be provided, and/or other additional functionality may be provided.

It will also be appreciated that, while various items are illustrated as being stored in memory or on storage while being used, these items or portions of them may be transferred between memory and other storage devices for purposes of memory management and data integrity. Alternatively, in other embodiments some or all of the software components and/or systems may execute in memory on another device and communicate with the illustrated computing systems via inter-computer communication. Thus, in some embodiments, some or all of the described techniques may be performed by hardware means that include one or more processors and/or memory and/or storage when configured by one or more software programs (*e.g*., by the ABIA system 350 executing on server computing systems 300, by the ICA system 368 executing on devices 360 and/or on server computing systems 300, by the MIGM system 389 executing on server computing systems 380 and/or on server computing systems 300, etc.) and/or data structures, such as by execution of software instructions of the one or more software programs and/or by storage of such software instructions and/or data structures, and such as to perform algorithms as described in the flow charts and other disclosure herein. Furthermore, in some embodiments, some or all of the systems and/or components may be implemented or provided in other manners, such as consisting of one or more means that are implemented partially or fully in firmware and/or hardware (*e.g*., rather than as a means implemented in whole or in part by software instructions that configure a particular CPU or other processor), including, but not limited to, one or more application-specific integrated circuits (ASICs), standard integrated circuits, controllers (*e.g.*, by executing appropriate instructions, and including microcontrollers and/or embedded controllers), field-programmable gate arrays (FPGAs), complex programmable logic devices (CPLDs), etc. Some or all of the components, systems and data structures may also be stored (*e.g.*, as software instructions or structured data) on a non-transitory computer-readable storage medium, such as a hard disk or flash drive or other non-volatile storage device, volatile or non-volatile memory (*e.g.*, RAM or flash RAM), a network storage device, or a portable media article (*e.g*., a DVD disk, a CD disk, an optical disk, a flash memory device, etc.) to be read by an appropriate drive or via an appropriate connection. The systems, components and data structures may also in some embodiments be transmitted via generated data signals (*e.g.*, as part of a carrier wave or other analog or digital propagated signal) on a variety of computer-readable transmission mediums, including wireless-based and wired/cable-based mediums, and may take a variety of forms (*e.g*., as part of a single or multiplexed analog signal, or as multiple discrete digital packets or frames). Such computer program products may also take other forms in other embodiments. Accordingly, embodiments of the present disclosure may be practiced with other computer system configurations.

Figure 4 illustrates an example embodiment of a flow diagram for an Automated Building Information Assessment (ABIA) system routine 400. The routine may be performed by, for example, execution of the ABIA system 150 of Figure 1A, the ABIA system 350 of Figure 3, and/or an ABIA system as described elsewhere herein, such as to analyze and assess building images as part of performing an automated assessment of characteristics of an automated mapping information generation process that is based at least in part on those images (*e.g*., to assess a predicted amount of time for the automated generation process to complete), and to provide instructions or other feedback (*e.g*., to one or more users participating in the image acquisition process) to improve the generation process. In the example of Figure 4, images of a building (*e.g*., 360° panorama images) are acquired and assessed as part of an automated generation process of a floor plan for the building with that floor plan then provided for one or more subsequent uses, but in other embodiments, other types of information may be acquired and assessed (whether in addition to and/or instead of the images) and/or other types of mapping-related information may generated (whether in addition to and/or instead of the floor plan) and used in other manners, including for other types of structures and defined areas, as discussed elsewhere herein.

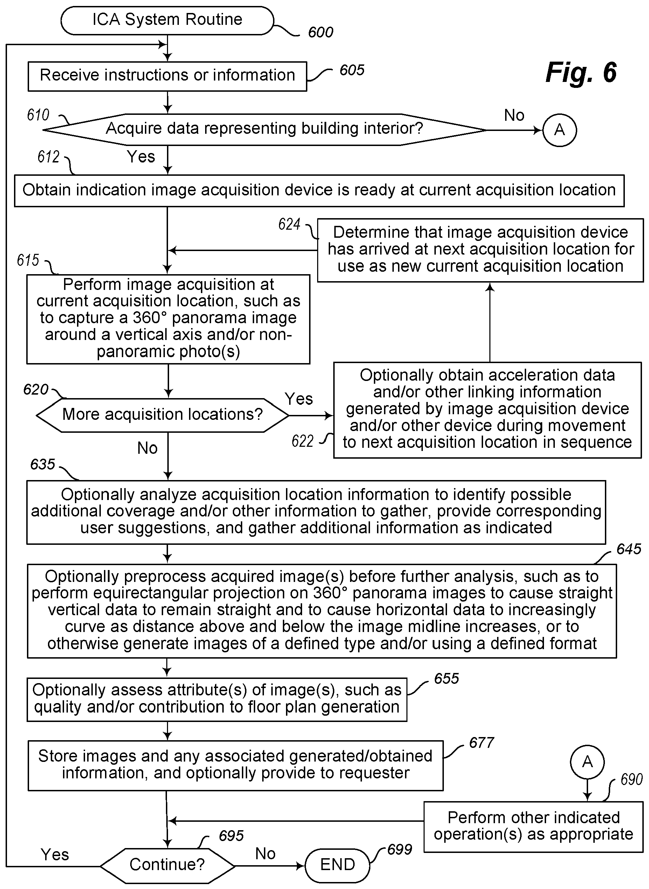

The illustrated embodiment of the routine begins at block 405, where information or instructions are received. The routine continues to block 410 to determine whether the information or instructions of block 405 indicate to acquire images and optionally other data representing a building and to perform associated assessments and feedback during the acquisition process, and if so continues to perform blocks 415-485, and otherwise continues to block 490. In block 415, the routine obtains information related to the acquisition process and a corresponding generation process of a floor plan and/or other mapping information for a building, such as to obtain information (*e.g.*, as received in block 405 or retrieved from storage or other sources) about the building, about one or more users participating in the acquisition process, about resources available for the generation process, etc., and optionally determines and provides an initial estimate of one or more characteristics of the generation process (*e.g.*, an estimated time to complete the generation process in light of the building information and acquiring users and available resources, such as based at least in part on other computing related activities to also be performed using some or all of the available resources) - in at least some embodiments, the initial estimate is provided to the one or more users involved in the acquisition process via a displayed GUI, such as on a mobile image acquisition computing device or on another mobile device associated with a camera device that will acquire the images. After block 415, the routine continues to block 420, where it performs an ICA system routine to acquire one or more images at the building (*e.g*., within an interior of the building, such as in one or more first rooms of the building) and optionally associated additional data (*e.g*., audio, acquisition metadata, etc.), and returns the acquired image(s) and any other acquired data and optionally any image-related assessments performed by the ICA system - one example of a routine for the ICA system is illustrated further with respect to Figure 6.

In block 430, the routine then assesses the one or more images acquired at the building to determine one or more attributes related to the contribution of the image(s) to the generation process of a floor plan for the building, and assesses corresponding characteristics of the generation process, such as to provide updated estimates of one or more characteristics that were initially assessed in block 415 - in addition, in at least some embodiments, the routine in block 430 further optionally determines an initial room shape for one or more rooms visible in the image(s), such as a rough or partial room shape that will later be refined to a final room shape by the MIGM system. After block 430, the routine continues to block 440, where it optionally performs an MIGM system routine to generate at least a partial floor plan for the building that is based at least in part on visual data of the acquired images, and returns the partial floor plan (if generated) and optionally any floor plan-related assessments performed by the MIGM system (*e.g.*, uncertainties associated with determined room shapes). After block 440, the routine continues to block 445, where it determines feedback to provide based on the assessments performed in block 430 and optionally in blocks 420 and/or 440, and provides the determined feedback to one or more users associated with the acquisition process (*e.g*., via a displayed GUI), such as to update initial estimate information (if any) provided in block 415 and to optionally display an initial estimated room shapes from block 430 and/or partial floor plan information from block 440 and/or some or all of the acquired image(s) along with the feedback. After block 445, the routine continues to block 450, where it determines whether there are more acquisition locations at which to acquire images for the building, and if so returns to block 420 to acquire one or more additional images.

If it is instead determined in block 450 that there are not additional acquisition locations at which to acquire additional images for the building, the routine continues to block 460, where it optionally determines a final estimate of the one or more characteristics of the generation process and provides them to the one or more users associated with the acquisition process (*e.g*., via a displayed GUI). In addition, if a final floor plan was not determined in block 440 during a last iteration of the blocks 415-445, the routine in block 460 optionally performs the MIGM system routine to determine a final floor plan and optionally other mapping information for the building, as well as to optionally display the final floor plan to the one or more users associated with the acquisition process (*e.g*., via a displayed GUI). After block 460, the routine continues to block 485, where it stores the information that is determined, generated and assessed with respect to blocks 415-460, and optionally provides some or all of the information (e.g., the generated final floor plan and/or other mapping information for the building) to one or more recipients for further use.

If it was instead determined in block 410 that the instructions or other information received in block 405 was not to acquire and assess data representing a building, the routine continues instead to block 490, where it performs one or more other indicated operations as appropriate. Non-exclusive examples of such other indicated operations include one or more of the following: to configure parameters to be used in various operations of the system (*e.g*., based at least in part on information specified by a user of the system, such as an operator user of the ASIA system, a user of a mobile device who acquires images for one or more building interiors and specifies preferences and/or settings to use for those acquisition and assessment processes, etc.), to respond to requests for generated and stored information (*e.g.*, for previously generated floor plans and/or other building mapping information, for previously determined assessments and/or feedback, etc.), to obtain and store other information about users of the system, to -perform any housekeeping tasks, etc.

Following blocks 485 or 490, the routine proceeds to block 495 to determine whether to continue, such as until an explicit indication to terminate is received, or instead only if an explicit indication to continue is received. If it is determined to continue, the routine returns to block 405 to await additional instructions or information, and if not proceeds to block 499 and ends.

While the routine 400 may in some embodiments operate in a synchronous manner (*e.g.,* waiting at blocks 420 and/or 440 to receive responses from the ICA and/or MIGM systems, respectively), in other embodiments the routine 400 may operate in an asynchronous manner, such as by performing other processing activities (*e.g.,* responding to other instructions or information received at block 405) while waiting at blocks 420 and/or 440 or otherwise while performing other processing. In addition, while not illustrated with respect to the automated operations shown in the example embodiment of Figure 4, in some embodiments human users may further assist in facilitating some of the operations of the ABIA system, such as for operator users and/or end users of the ABIA system to provide input of one or more types that is further used in subsequent automated operations, as discussed elsewhere herein.

Figure 6 illustrates an example flow diagram of an embodiment of an ICA (Image Capture & Analysis) system routine 600. The routine may be performed by, for example, the ICA system 160 of Figure 1A, the ICA system 368 of Figure 3, and/or as otherwise described herein, such as to acquire 360° panorama images and/or other images at acquisition locations within buildings or other structures, such as for use in subsequent generation of related floor plans and/or other mapping information. While portions of the example routine 600 are discussed with respect to acquiring particular types of images at particular acquisition locations, it will be appreciated that this or a similar routine may be used to acquire video or other data (*e.g.,* audio), whether instead of or in addition to such images. In addition, while the illustrated embodiment acquires and uses information from the interior of a target building, it will be appreciated that other embodiments may perform similar techniques for other types of data, including for non-building structures and/or for information external to one or more target buildings of interest. Furthermore, some or all of the routine may be executed on a mobile device used by a user to acquire image information, and/or by a system remote from such a mobile device. In at least some embodiments, the routine 600 may be invoked from block 420 of routine 400 of Figure 4, with corresponding information from routine 600 provided to routine 400 as part of implementation of that block 420, and with processing control returned to routine 400 after blocks 677 and/or 699 in such situations - in other embodiments, the routine 400 may proceed with additional operations in an asynchronous manner without waiting for such processing control to be returned (*e.g.,* to proceed to block 430 once the corresponding information from routine 600 is provided to routine 400, to proceed with other processing activities while waiting for the corresponding information from the routine 600 to be provided to routine 400, etc.).

The illustrated embodiment of the routine begins at block 605, where instructions or information are received. At block 610, the routine determines whether the received instructions or information indicate to acquire visual data and/or other data representing a building interior, and if not continues to block 690. Otherwise, the routine proceeds to block 612 to receive an indication to begin the image acquisition process at a first acquisition location (*e.g.,* from a user of a mobile image acquisition device that will perform the acquisition process). After block 612, the routine proceeds to block 615 in order to perform acquisition location image acquisition activities for acquiring a 360° panorama image for the acquisition location in the interior of the target building of interest, such as via one or more fisheye lenses and/or non-fisheye rectilinear lenses on the mobile device and to provide horizontal coverage of at least 360° around a vertical axis, although in other embodiments other types of images and/or other types of data may be acquired. As one non-exclusive example, the mobile image acquisition device may be a rotating (scanning) panorama camera equipped with a fisheye lens (*e.g.,* with 180° degrees of horizontal coverage) and/or other lens (*e.g.,* with less than 180° degrees of horizontal coverage, such as a regular lens or wide-angle lens or ultrawide lens). The routine may also optionally obtain annotation and/or other information from the user regarding the acquisition location and/or the surrounding environment, such as for later use in presentation of information regarding that acquisition location and/or surrounding environment.

After block 615 is completed, the routine continues to block 620 to determine if there are more acquisition locations at which to acquire images, such as based on corresponding information provided by the user of the mobile device - in some embodiments, the ICA routine will acquire only a single image and then proceed to block 677 to provide that image and corresponding information (*e.g.,* to return the image and corresponding information to the ASIA system and/or MIGM system for further use before receiving additional instructions or information to acquire one or more next images at one or more next acquisition locations. If there are more acquisition locations at which to acquire additional images at the current time, when the user is ready to continue the process, the routine continues to block 622 to optionally initiate the capture of linking information (*e.g.,* acceleration data) during movement of the mobile device along a travel path away from the current acquisition location and towards a next acquisition location within the building interior. The captured linking information may include additional sensor data (*e.g.,* from one or more IMU, or inertial measurement units, on the mobile device or otherwise carried by the user) and/or additional visual information (*e.g.,* images, video, etc.) recorded during such movement. Initiating the capture of such linking information may be performed in response to an explicit indication from a user of the mobile device or based on one or more automated analyses of information recorded from the mobile device. In addition, the routine may further optionally monitor the motion of the mobile device in some embodiments during movement to the next acquisition location, and provide one or more guidance cues to the user regarding the motion of the mobile device, quality of the sensor data and/or visual information being captured, associated lighting/environmental conditions, advisability of capturing a next acquisition location, and any other suitable aspects of capturing the linking information. Similarly, the routine may optionally obtain annotation and/or other information from the user regarding the travel path, such as for later use in presentation of information regarding that travel path or a resulting inter-panorama image connection link. In block 624, the routine determines that the mobile device has arrived at the next acquisition location (*e.g.,* based on an indication from the user, based on the forward movement of the user stopping for at least a predefined amount of time, etc.), for use as the new current acquisition location, and returns to block 615 in order to perform the acquisition location image acquisition activities for the new current acquisition location.

If it is instead determined in block 620 that there are not any more acquisition locations at which to acquire image information for the current building or other structure at the current time, the routine proceeds to block 635 to optionally analyze the acquisition location information for the building or other structure, such as to identify possible additional coverage (and/or other information) to acquire within the building interior, to optionally provide corresponding instructions or other feedback to the user and/or image acquisition device, and to optionally gather additional information as indicated (*e.g.,* one or more replacement images, one or more additional new images, etc.) - while not illustrated in the example embodiment, in some embodiments the routine 600 may instead receive some or all such feedback from an external source (*e.g.,* the ABIA system, such as after sending one or more of the images acquired at block 615 to the ASIA system before reaching block 635, not shown). For example, the ICA system may provide one or more notifications to the user regarding the information acquired during capture of the multiple acquisition locations and optionally corresponding linking information, such as if it determines that one or more segments of the captured information are of insufficient or undesirable quality, or do not appear to provide complete coverage of the building. After block 635, the routine continues to block 645 to optionally preprocess the acquired 360° panorama images before their subsequent use for generating related mapping information, such as to produce images of a particular type and/or in a particular format (*e.g.,* to perform an equirectangular projection for each such image, with straight vertical data such as the sides of a typical rectangular door frame or a typical border between 2 adjacent walls remaining straight, and with straight horizontal data such as the top of a typical rectangular door frame or a border between a wall and a floor remaining straight at a horizontal midline of the image but being increasingly curved in the equirectangular projection image in a convex manner relative to the horizontal midline as the distance increases in the image from the horizontal midline). In block 655, the routine then optionally assesses one or more attributes of the acquired image(s), such as with respect to quality of the image(s) or otherwise to assess a degree of contribution of the visual data of the image(s) to a generation process (*e.g.,* in generating a floor plan and/or other mapping information for the building), although in other embodiments such assessments may be performed by another routine (*e.g.,* by routine 400 of the ASIA system) or may not be performed. In block 677, the images and any associated generated or obtained information is stored for later use, and optionally provided to one or more recipients (*e.g.,* to block 420 of routine 400 if invoked from that block). Figures 5A-5B illustrate one example of a routine for generating a floor plan representation of a building interior from the generated panorama information.

If it is instead determined in block 610 that the instructions or other information recited in block 605 are not to acquire images and other data representing a building interior, the routine continues instead to block 690 to perform any other indicated operations as appropriate, such as any housekeeping tasks, to configure parameters to be used in various operations of the system (*e.g.,* based at least in part on information specified by a user of the system, such as a user of a mobile device who captures one or more building interiors, an operator user of the ICA system, etc.), to respond to requests for generated and stored information (*e.g.,* to identify one or more groups of inter-connected linked panorama images each representing a building or part of a building that match one or more specified search criteria, one or more panorama images that match one or more specified search criteria, etc.), to generate and store inter-panorama image connections between panorama images for a building or other structure (*e.g.,* for each panorama image, to determine directions within that panorama image toward one or more other acquisition locations of one or more other panorama images, such as to enable later display of an arrow or other visual representation with a panorama image for each such determined direction from the panorama image to enable an end-user to select one of the displayed visual representations to switch to a display of the other panorama image at the other acquisition location to which the selected visual representation corresponds), to obtain and store other information about users of the system, etc.

Following blocks 677 or 690, the routine proceeds to block 695 to determine whether to continue, such as until an explicit indication to terminate is received, or instead only if an explicit indication to continue is received. If it is determined to continue, the routine returns to block 605 to await additional instructions or information, and if not proceeds to step 699 and ends.

Figures 5A-5B illustrate an example embodiment of a flow diagram for a MIGM (Mapping Information Generation Manager) system routine 500. The routine may be performed by, for example, execution of the MIGM system 140 of Figure 1A, the MIGM system 389 of Figure 3, and/or a MIGM system as described elsewhere herein, such as to determine a room shape for a room (or other defined area) by analyzing information from one or more images acquired in the room (*e.g.,* one or more 360° panorama images), to generate a floor plan for a building or other defined area based at least in part on one or more images of the area and optionally additional data captured by a mobile computing device, and/or to generate other mapping information for a building or other defined area based at least in part on one or more images of the area and optionally additional data captured by a mobile computing device. In the example of Figures 5A-5B, the determined room shape for a room may be a 3D fully closed combination of planar surfaces to represent the walls and ceiling and floor of the room, and the generated mapping information for a building (*e.g.,* a house) may include a 2D floor plan and/or 3D computer model floor plan, but in other embodiments, other types of room shapes and/or mapping information may be generated and used in other manners (*e.g.,* to generate 2D room shapes), including for other types of structures and defined areas, as discussed elsewhere herein. In at least some embodiments, the routine 500 may be invoked from block 440 of routine 400 of Figure 4, with corresponding information from routine 500 provided to routine 400 as part of implementation of that block 440, and with processing control returned to routine 400 after blocks 588 and/or 599 in such situations - in other embodiments, the routine 400 may proceed with additional operations in an asynchronous manner without waiting for such processing control to be returned (*e.g.,* to proceed to block 445 once the corresponding information from routine 500 is provided to routine 400, to proceed with other processing activities while waiting for the corresponding information from the routine 500 to be provided to routine 400, etc.).

The illustrated embodiment of the routine begins at block 505, where information or instructions are received. The routine continues to block 510 to determine whether image information is already available to be analyzed for one or more rooms (*e.g.,* for some or all of an indicated building, such as based on one or more such images received in block 505), or if such image information instead is to be currently acquired. If it is determined in block 510 to currently acquire some or all of the image information, the routine continues to block 512 to acquire such information, optionally waiting for one or more users or devices to move throughout one or more rooms of a building and acquire panoramas or other images at one or more acquisition locations in one or more of the rooms (*e.g.,* at multiple acquisition locations in each room of the building), optionally along with metadata information regarding the acquisition and/or interconnection information related to movement between acquisition locations, as discussed in greater detail elsewhere herein - implementation of block 512 may, for example, include invoking an ICA system routine to perform such activities, with Figure 6 providing one example embodiment of an ICA system routine for performing such image acquisition. If it is instead determined in block 510 not to currently acquire the images, the routine continues instead to block 515 to obtain one or more existing panoramas or other images from one or more acquisition locations in one or more rooms (*e.g.,* multiple images acquired at multiple acquisition locations that include at least one image and acquisition location in each room of a building), optionally along with metadata information regarding the acquisition and/or interconnection information related to movement between the acquisition locations, such as may in some situations have been supplied in block 505 along with the corresponding instructions.

After blocks 512 or 515, the routine continues to block 520, where it determines whether to generate mapping information that includes a linked set of target panorama images (or other images) for a building or other group of rooms (referred to at times as a 'virtual tour', such as to enable an end user to move from any one of the images of the linked set to one or more other images to which that starting current image is linked, including in some embodiments via selection of a user-selectable control for each such other linked image that is displayed along with a current image, optionally by overlaying visual representations of such user-selectable controls and corresponding inter-image directions on the visual data of the current image, and to similarly move from that next image to one or more additional images to which that next image is linked, etc.), and if so continues to block 525. The routine in block 525 selects pairs of at least some of the images (*e.g.,* based on the images of a pair having overlapping visual content), and determines, for each pair, relative directions between the images of the pair based on shared visual content and/or on other captured linking interconnection information (*e.g.,* movement information) related to the images of the pair (whether movement directly from the acquisition location for one image of a pair to the acquisition location of another image of the pair, or instead movement between those starting and ending acquisition locations via one or more other intermediary acquisition locations of other images). The routine in block 525 may further optionally use at least the relative direction information for the pairs of images to determine global relative positions of some or all of the images to each other in a common coordinate system, and/or generate the inter-image links and corresponding user-selectable controls as noted above. Additional details are included elsewhere herein regarding creating such a linked set of images.

After block 525, or if it is instead determined in block 520 that the instructions or other information received in block 505 are not to determine a linked set of images, the routine continues to block 530 to determine whether the instructions received in block 505 indicate to determine the shape of one or more rooms from previously or currently acquired images in the rooms (*e.g.,* from one or multiple panorama images acquired in each of the rooms), and if so continues to block 545. Otherwise, the routine continues to block 535 to determine whether the instructions received in block 505 indicate to generate other mapping information for an indicated building (e.g., a floor plan), and if so the routine continues to perform blocks 537-585 to do so, and otherwise continues to block 590.

In block 537, the routine optionally obtains additional information about the building, such as from activities performed during acquisition and optionally analysis of the images, and/or from one or more external sources (*e.g.,* online databases, information provided by one or more end users, etc.) - such additional information may include, for example, exterior dimensions and/or shape of the building, additional images and/or annotation information acquired corresponding to particular locations within the building (optionally for locations different from acquisition locations of the acquired panorama or other images), additional images and/or annotation information acquired corresponding to particular locations external to the building (*e.g.,* surrounding the building and/or for other structures on the same property), etc.

After block 537, the routine continues to block 540 to determine whether to generate room shapes of rooms enclosing acquired images of a building for use in generating a floor plan for the building, and if not (*e.g.,* if room shape information is already available for the rooms of the building) continues to block 570. Otherwise, if it is determined in block 540 to determine room shapes for generating a floor plan for the building, or in block 530 to determine one or more room shapes from acquired images (*e.g.,* without generating other mapping-related information), the routine continues to perform blocks 545-555 to generate the room shapes for one or more rooms.

In particular, the routine in block 545 proceeds to select the next room (beginning with the first) for which one or more images (*e.g.,* 360° panorama images) acquired in the room are available, to determine initial pose information for each of those panorama images (*e.g.,* as supplied with acquisition metadata for the panorama image), and to optionally obtain additional metadata for each panorama image (*e.g.,* acquisition height information of the camera device or other image acquisition device used to acquire a panorama image relative to the floor and/or the ceiling). The routine in block 545 further analyzes the visual data of the image(s) for the room to determine a room shape (*e.g.,* by determining at least wall locations) and optionally to identify other wall and floor and ceiling elements (*e.g.,* wall structural elements/features, such as windows, doorways and stairways and other inter-room wall openings and connecting passages, wall borders between a wall and another wall and/or receiving and/or a floor, etc.) and their positions within the determined room shape of the room *(e.g.,* by generating a 3D point cloud of some or all of the room walls and optionally the ceiling and/or floor, such as by analyzing at least visual data of the panorama image and optionally additional data captured by an image acquisition device or associated mobile computing device, optionally using one or more of SfM (Structure from Motion) or SLAM (Simultaneous Location And Mapping) or MVS (Multi-View Stereo) analysis). Additional details are included elsewhere herein regarding determining room shapes and identifying additional information for the rooms, including initial estimated acquisition pose information for images acquired in the rooms.

After block 545, the routine continues to block 555, where it determines whether there are more rooms for which to determine room shapes based on images acquired in those rooms, and if so returns to block 545 to select the next such room for which to determine a room shape.

If it is instead determined in block 555 that there are not more rooms for which to generate room shapes, or in block 540 to not determine room shapes, the routine continues to block 570 to determine whether to further generate a floor plan for the building (*e.g.,* based at least in part on the determined room shapes from block 545, and optionally further information regarding how to position the determined room shapes relative to each other). If not, such as when determining only room shapes without generating further mapping information for a building (*e.g.,* to determine the room shape for a single room for the ASIA system based on one or more images acquired in the room by the ICA system), the routine continues to block 588. Otherwise, the routine continues to block 575 to retrieve room shapes (*e.g.,* room shapes generated in block 545) or otherwise obtain room shapes (*e.g.,* based on human-supplied input) for rooms of the building, whether 2D or 3D room shapes, and then continues to block 577. In block 577, the routine uses the room shapes to create an initial 2D floor plan using 2D room shapes (*e.g.,* determining a corresponding 2D room shape for a 3D room shape by using wall location information of the 3D room shape), by connecting inter-room passages in their respective rooms, by optionally positioning room shapes around determined acquisition locations of the target images (*e.g.,* if the acquisition location positions are inter-connected and in a common global coordinate system), and by optionally applying one or more constraints or optimizations. Such a floor plan may include, for example, relative position and shape information for the various rooms without providing any actual dimension information for the individual rooms or building as a whole, and may further include multiple linked or associated sub-maps (*e.g.,* to reflect different stories, levels, sections, etc.) of the building. The routine further associates positions of the doors, wall openings and other identified wall elements on the floor plan. After block 577, the routine optionally performs one or more steps 580-583 to determine and associate additional information with the floor plan. In block 580, the routine optionally estimates the dimensions of some or all of the rooms, such as from analysis of images and/or their acquisition metadata or from overall dimension information obtained for the exterior of the building, and associates the estimated dimensions with the floor plan - it will be appreciated that if sufficiently detailed dimension information were available, architectural drawings, blueprints, etc. may be generated from the floor plan. After block 580, the routine continues to block 583 to optionally associate further information with the floor plan (*e.g.,* with particular rooms or other locations within the building), such as additional existing images with specified positions and/or annotation information. In block 585, if the room shapes from block 575 are not 3D room shapes, the routine further estimates heights of walls in some or all rooms, such as from analysis of images and optionally sizes of known objects in the images, as well as height information about a camera when the images were acquired, and uses that height information to generate 3D room shapes for the rooms - the routine further uses the 3D room shapes (whether from block 575 or block 585) to generate a 3D computer model floor plan of the building, with the 2D and 3D floor plans being associated with each other - in other embodiments, only a 3D computer model floor plan may be generated and used (including to provide a visual representation of a 2D floor plan if so desired by using a horizontal slice of the 3D computer model floor plan).

After block 585, or if it is instead determined in block 570 not to determine a floor plan, the routine continues to block 588 to store the determined room shape(s) and/or generated mapping information and/or other generated information, to optionally provide some or all of that information to one or more recipients (*e.g.,* to block 440 of routine 400 if invoked from that block), and to optionally further use some or all of the determined and generated information, such as to provide the generated 2D floor plan and/or 3D computer model floor plan for display on one or more client devices and/or to one or more other devices for use in automating navigation of those devices and/or associated vehicles or other entities, to similarly provide and use information about determined room shapes and/or a linked set of panorama images and/or about additional information determined about contents of rooms and/or passages between rooms, etc.

If it is instead determined in block 535 that the information or instructions received in block 505 are not to generate mapping information for an indicated building, the routine continues instead to block 590 to perform one or more other indicated operations as appropriate. Such other operations may include, for example, receiving and responding to requests for previously generated floor plans and/or previously determined room shapes and/or other generated information (*e.g.,* requests for such information for display on one or more client devices, requests for such information to provide it to one or more other devices for use in automated navigation, etc.), obtaining and storing information about buildings for use in later operations (*e.g.,* information about dimensions, numbers or types of rooms, total square footage, adjacent or nearby other buildings, adjacent or nearby vegetation, exterior images, etc.), etc.

After blocks 588 or 590, the routine continues to block 595 to determine whether to continue, such as until an explicit indication to terminate is received, or instead only if an explicit indication to continue is received. If it is determined to continue, the routine returns to block 505 to wait for and receive additional instructions or information, and otherwise continues to block 599 and ends.

While not illustrated with respect to the automated operations shown in the example embodiment of Figures 5A-5B, in some embodiments human users may further assist in facilitating some of the operations of the MIGM system, such as for operator users and/or end users of the MIGM system to provide input of one or more types that is further used in subsequent automated operations. As non-exclusive examples, such human users may provide input of one or more types as follows: to provide input to assist with the linking of a set of images, such as to provide input in block 525 that is used as part of the automated operations for that block (*e.g.,* to specify or adjust initial automatically determined directions between one or more pairs of images, to specify or adjust initial automatically determined final global positions of some or all of the images relative to each other, etc.); to provide input in block 537 that is used as part of subsequent automated operations, such as one or more of the illustrated types of information about the building; to provide input with respect to block 545 that is used as part of subsequent automated operations, such as to specify or adjust initial automatically determined pose information (whether initial pose information or subsequent updated pose information) for one or more of the panorama images and/or to specify or adjust initial automatically determined element locations and/or estimated room shapes and/or to manually combine information from multiple estimated room shapes for a room (*e.g.,* separate room shape estimates from different images acquired in the room) to create a final room shape for the room and/or to specify or adjust initial automatically determined information about a final room shape, etc.; to provide input with respect to block 577, that is used as part of subsequent operations, such as to specify or adjust initial automatically determined positions of room shapes within a floor plan being generated and/or to specify or adjust initial automatically determined room shapes themselves within such a floor plan; to provide input with respect to one or more of blocks 580 and 583 and 585 that is used as part of subsequent operations, such as to specify or adjust initial automatically determined information of one or more types discussed with respect to those blocks; etc. Additional details are included elsewhere herein regarding embodiments in which one or more human users provide input that is further used in additional automated operations of the ASIA system.

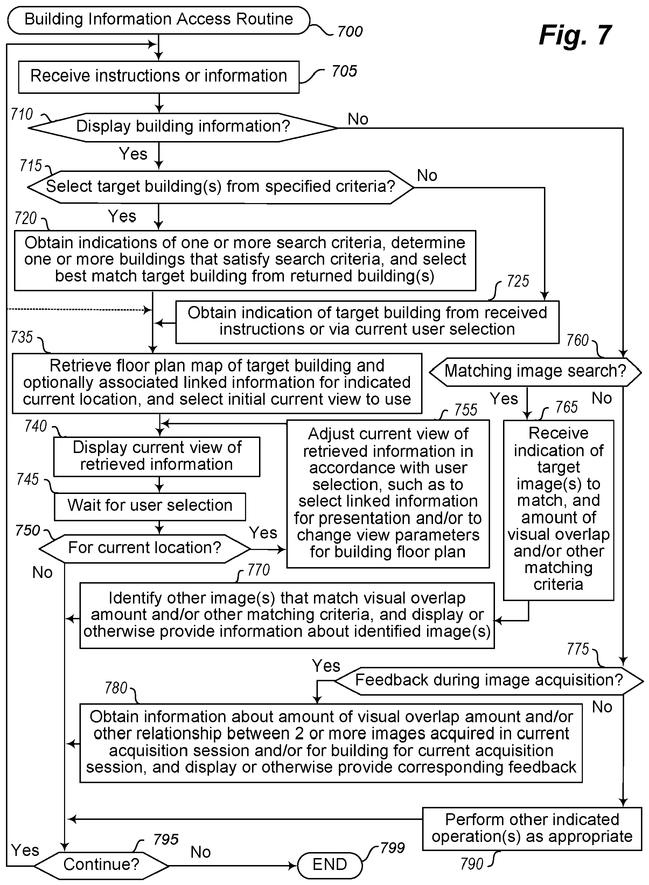

Figure 7 illustrates an example embodiment of a flow diagram for a Building Information Access system routine 700. The routine may be performed by, for example, execution of a building information access client computing device 175 and its software system(s) (not shown) of Figure 1A, a client computing device 390 and/or mobile computing device 360 of Figure 3, and/or a mapping information access viewer or presentation system as described elsewhere herein, such as to receive and display generated floor plans and/or other mapping information (*e.g.,* a 3D model floor plan, determined room structural layouts/shapes, etc.) for a defined area that optionally includes visual indications of one or more determined image acquisition locations, to obtain and display information about images matching one or more indicated target images, to obtain and display feedback corresponding to one or more indicated target images acquired during an image acquisition session (*e.g.,* with respect to other images acquired during that acquisition session and/or for an associated building), to display additional information (*e.g.,* images) associated with particular acquisition locations in the mapping information, to display feedback provided by the ASIA system and/or other sources (*e.g.,* as part of a displayed GUI), etc. In the example of Figure 7, the presented mapping information is for a building (such as an interior of a house), but in other embodiments, other types of mapping information may be presented for other types of buildings or environments and used in other manners, as discussed elsewhere herein.

The illustrated embodiment of the routine begins at block 705, where instructions or information are received. At block 710, the routine determines whether the received instructions or information in block 705 are to display determined information for one or more target buildings, and if so continues to block 715 to determine whether the received instructions or information in block 705 are to select one or more target buildings using specified criteria, and if not continues to block 720 to obtain an indication of a target building to use from the user (*e.g.,* based on a current user selection, such as from a displayed list or other user selection mechanism; based on information received in block 705; etc.). Otherwise, if it is determined in block 715 to select one or more target buildings from specified criteria, the routine continues instead to block 725, where it obtains indications of one or more search criteria to use, such as from current user selections or as indicated in the information or instructions received in block 705, and then searches stored information about buildings to determine one or more of the buildings that satisfy the search criteria. In the illustrated embodiment, the routine then further selects a best match target building from the one or more returned buildings (*e.g.,* the returned other building with the highest similarity or other matching rating for the specified criteria, or using another selection technique indicated in the instructions or other information received in block 705).

After blocks 720 or 725, the routine continues to block 735 to retrieve a floor plan for the target building or other generated mapping information for the building, and optionally indications of associated linked information for the building interior and/or a surrounding location external to the building, and selects an initial view of the retrieved information (*e.g.,* a view of the floor plan, a particular room shape, etc.). In block 740, the routine then displays or otherwise presents the current view of the retrieved information, and waits in block 745 for a user selection. After a user selection in block 745, if it is determined in block 750 that the user selection corresponds to adjusting the current view for the current target building (*e.g.,* to change one or more aspects of the current view), the routine continues to block 755 to update the current view in accordance with the user selection, and then returns to block 740 to update the displayed or otherwise presented information accordingly. The user selection and corresponding updating of the current view may include, for example, displaying or otherwise presenting a piece of associated linked information that the user selects (*e.g.,* a particular image associated with a displayed visual indication of a determined acquisition location, such as to overlay the associated linked information over at least some of the previous display), and/or changing how the current view is displayed (*e.g.,* zooming in or out; rotating information if appropriate; selecting a new portion of the floor plan to be displayed or otherwise presented, such as with some or all of the new portion not being previously visible, or instead with the new portion being a subset of the previously visible information; etc.). If it is instead determined in block 750 that the user selection is not to display further information for the current target building (*e.g.,* to display information for another building, to end the current display operations, etc.), the routine continues instead to block 795, and returns to block 705 to perform operations for the user selection if the user selection involves such further operations.

If it is instead determined in block 710 that the instructions or other information received in block 705 are not to present information representing a building, the routine continues instead to block 760 to determine whether the instructions or other information received in block 705 correspond to identifying other images (if any) corresponding to one or more indicated target images, and if continues to blocks 765-770 to perform such activities. In particular, the routine in block 765 receives the indications of the one or more target images for the matching (such as from information received in block 705 or based on one or more current interactions with a user) along with one or more matching criteria (*e.g.,* an amount of visual overlap), and in block 770 identifies one or more other images (if any) that match the indicated target image(s), such as by interacting with the MIGM system to obtain the other image(s). The routine then displays or otherwise provides information in block 770 about the identified other image(s), such as to provide information about them as part of search results, to display one or more of the identified other image(s), etc. If it is instead determined in block 760 that the instructions or other information received in block 705 are not to identify other images corresponding to one or more indicated target images, the routine continues instead to block 775 to determine whether the instructions or other information received in block 705 correspond to obtaining and providing feedback during an image acquisition session with respect to one or more indicated target images (*e.g.,* a most recently acquired image), and if so continues to block 780, and otherwise continues to block 790. In block 780, the routine obtains information about feedback of one or more types (*e.g.,* an amount of visual overlap and/or other relationship between the indicated target image(s) and other images acquired during the current image acquisition session and/or acquired for the current building), such as by interacting with the ASIA system, and displays or otherwise provides feedback in block 780 about the feedback.

In block 790, the routine continues instead to perform other indicated operations as appropriate, such as to configure parameters to be used in various operations of the system (*e.g.,* based at least in part on information specified by a user of the system, such as a user of a mobile device who acquires one or more building interiors, an operator user of the ASIA and/or MIGM systems, etc., including for use in personalizing information display for a particular user in accordance with his/her preferences), to obtain and store other information about users of the system, to respond to requests for generated and stored information, to perform any housekeeping tasks, etc.

Following blocks 770 or 780 or 790, or if it is determined in block 750 that the user selection does not correspond to the current building, the routine proceeds to block 795 to determine whether to continue, such as until an explicit indication to terminate is received, or instead only if an explicit indication to continue is received. If it is determined to continue (including if the user made a selection in block 745 related to a new building to present), the routine returns to block 705 to await additional instructions or information (or to continue directly on to block 735 if the user made a selection in block 745 related to a new building to present), and if not proceeds to step 799 and ends.

Non-exclusive example embodiments described herein are further described in the following clauses.
A01. A computer-implemented method for one or more computing devices to perform automated operations comprising:
   acquiring, by one of the one or more computing devices that has one or more cameras and is under control of a user, one or more first panorama images at one or more first acquisition locations in one or more first rooms of a building that has multiple rooms, wherein each of the first panorama images is in a spherical format and includes 360 degrees of horizontal visual coverage around a vertical axis and has visual coverage of at least some walls of one of the first rooms that contains the respective first acquisition location for that first panorama image;
   analyzing, by the one computing device, first visual data of the one or more first panorama images to assess first attributes of the first visual data affecting an automated floor plan generation process that generates a floor plan for the building and is based on the first visual data and on further visual data to be acquired in additional panorama images at later times at additional acquisition locations in additional rooms for the building;
   predicting, by the one computing device and based at least in part on the assessed first attributes of the first visual data, one or more characteristics of the automated floor plan generation process that include a predicted amount of time to complete generation of the floor plan for the building;
   providing, by the one computing device, feedback to the user that includes the predicted amount of time and information about the assessed first attributes of the first visual data, to cause improvements in the automated floor plan generation process from acquiring of the additional panorama images by the user; and
   repeatedly updating, by the one computing device, the predicted one or more characteristics of the automated floor plan generation process based on further images acquired for the building, including, for each of multiple iterations:
      acquiring, by the one computing device, one or more second panorama images of the additional panorama images at one or more additional second acquisition locations for the building, wherein at least one of the second panorama images are acquired in at least one second room of the multiple rooms and have visual coverage of at least some walls of the at least one second room;
      analyzing, by the one computing device, second visual data of the one or more second panorama images to assess second attributes of the second visual data that further affect the automated floor plan generation process, the second attributes being based in part on an overlap of the second visual data with other visual data of one or more prior panorama images and being based in part on quality of the second visual data;
      predicting, by the one computing device and based at least in part on the assessed second attributes, one or more updated characteristics of the automated floor plan generation process that include a revised predicted amount of time to complete the generation of the floor plan for the building; and
      providing, by the one computing device, further feedback to the user that includes the revised predicted amount of time and information about the assessed second attributes of the second visual data, to cause further improvements in the automated floor plan generation process.
A02. A computer-implemented method for one or more computing devices to perform automated operations comprising:
   obtaining, by the one or more computing devices and for a building with multiple rooms, one or more first images acquired by one or more users at one or more first acquisition locations in a subset of the multiple rooms, wherein each of the first images has visual coverage of at least some walls of one of the multiple rooms in which the respective first acquisition location for that first image is located;
   analyzing, by the one or more computing devices, visual data of the one or more first images to assess one or more attributes of the one or more first images;
   predicting, by the one or more computing devices and based at least in part on the assessed one or more attributes of the one or more first images, one or more characteristics of an automated generation process to produce a floor plan for the building, wherein the automated generation process is based on analysis of the visual data of the one or more first images and is based on future analysis of additional images to be acquired at additional acquisition locations for the building, and wherein the predicted one or more characteristics include a predicted amount of time to complete the floor plan for the building;
   presenting, by the one or more computing devices, feedback to the one or more users that includes at least the predicted amount of time, to enable improvement in the additional images to be acquired;
   obtaining, by the one or more computing devices, one or more second images of the additional images that are acquired by the one or more users at one or more additional second acquisition locations for the building;
   analyzing, by the one or more computing devices, visual data of the one or more second images to assess at least one attribute of the one or more second images;
   predicting, by the one or more computing devices and based at least in part on the assessed at least one attribute of the one or more second images, one or more updated characteristics of the automated generation process that include a revised predicted amount of time to complete the floor plan for the building; and
   presenting, by the one or more computing devices, revised feedback to the one or more users that includes at least the revised predicted amount of time, to enable further improvement in the automated generation process.
A03. A computer-implemented method for one or more computing devices to perform automated operations comprising:
   obtaining, for a building with multiple rooms, one or more first images acquired at one or more first acquisition locations in one or more first rooms of the multiple rooms, wherein each of the first images has visual coverage of at least some walls of one of the first rooms that includes the respective first acquisition location for that first image;
   analyzing visual data of the one or more first images to assess one or more attributes of the one or more first images;
   generating, based at least in part on the assessed one or more attributes of the one or more first images, one or more predicted characteristics of a generation process for producing mapping information for the building that include a predicted amount of time for the producing of the mapping information, wherein the generation process is based at least in part on analysis of the visual data of the one or more first images and on future analysis of additional images to be acquired at additional acquisition locations for the building;
   providing feedback that includes at least the predicted amount of time, to enable improvement in the generation process resulting at least in part from the additional images to be acquired;
   obtaining one or more second images of the additional images that are acquired at one or more additional second acquisition locations for the building;
   analyzing visual data of the one or more second images to assess at least one attribute of the one or more second images;
   generating, based at least in part on the assessed at least one attribute of the one or more second images, one or more updated predicted characteristics of the generation process that include a revised predicted amount of time for the producing of the mapping information for the building; and
   using at least the revised predicted amount of time to enable further improvement in the generation process.
A04. A computer-implemented method for one or more computing devices to perform automated operations comprising:
   obtaining, by the one or more computing devices and for a building with multiple rooms, one or more first images acquired by one or more users at one or more first acquisition locations in one or more first rooms, wherein each of the first images has visual coverage of at least some walls of one of the first rooms that includes the respective first acquisition location for that first image;
   analyzing, by the one or more computing devices, visual data of the one or more first images to assess one or more attributes of the one or more first images;
   predicting, by the one or more computing devices and based at least in part on the assessed one or more attributes of the one or more first images, one or more characteristics of an automated generation process for producing a floor plan for the building, wherein the automated generation process is based on analysis of the visual data of the one or more first images and is based on future analysis of additional images to be acquired at additional acquisition locations for the building, and wherein the predicted one or more characteristics include a predicted amount of one or more resources involved with the producing of the floor plan for the building;
   providing, by the one or more computing devices, feedback to the one or more users that includes at least the predicted amount of the one or more resources, to enable improvement in the automated generation process resulting at least in part from acquiring of the additional images;
   obtaining, by the one or more computing devices, one or more second images of the additional images that are acquired by the one or more users at one or more additional second acquisition locations for the building;
   analyzing, by the one or more computing devices, visual data of the one or more second images to assess at least one attribute of the one or more second images;
   predicting, by the one or more computing devices and based at least in part on the assessed at least one attribute of the one or more second images, one or more updated characteristics of the automated generation process that include a revised predicted amount of the one or more resources involved with the producing of the floor plan for the building; and
   providing, by the one or more computing devices, revised feedback to the one or more users that includes at least the revised predicted amount of the one or more resources, to enable further improvement in the automated generation process.
A05. The computer-implemented method of any one of clauses A01-A04 wherein the providing of the feedback and of the further feedback includes displaying the feedback and the further feedback in a graphical user interface shown on the one or more computing devices, and wherein the method further comprises:
   before the repeated updating, generating, by the one or more computing devices and for each of the one or more first rooms, an initial estimate of a room shape for that first room using the first visual data, and displaying, together with the feedback to the user, a visual representation for each of the one or more first rooms of the generated initial estimate of the room shape for that first room; and
   for each of the multiple iterations, generating, by the one or more computing devices and for each of the at least one second rooms at which the at least one second panorama image for that iteration is acquired, an initial estimate of a room shape for that at least one second room using the second visual data, and displaying, together with the further feedback to the user, a further visual representation for each of the at least one second rooms of the generated initial estimate of the room shape for that at least one second room,
   and wherein generating of the predicted amount of time to complete the generation of the floor plan for the building is based at least in part on first room shape uncertainties associated with the generated initial estimates of the room shapes for each of the first rooms,
   and wherein generating of the revised predicted amount of time for each of the multiple iterations is based at least in part on second room shape uncertainties associated with the generated initial estimates of the room shapes for each of the at least one second rooms for that iteration.
A06. The computer-implemented method of clause A05 further comprising:
   transmitting, by the one or more computing devices and to one or more server computing systems over one or more computer networks, the one or more first panorama images and, for each of the multiple iterations, the one or more second panorama images acquired for that iteration;
   performing, by the one or more server computing systems, the automated floor plan generation process using the first visual data and using the second visual data of the one or more second panorama images acquired for each of the multiple iterations, including to determine final room shapes for the multiple rooms and to generate the floor plan for the building using the final room shapes;
   transmitting, by the one or more server computing systems and to the one or more computing devices over the one or more computer networks, the generated floor plan for the building; and
   displaying, by the one or more computing devices and to the user, the generated floor plan for the building.
A07. The computer-implemented method of clause A06 further comprising:
   before the acquiring of the one or more first panorama images,
      determining, by the one or more computing devices, computing resources available to the server computing system at a current time for the automated floor plan generation process; and
      presenting, by the one or more computing devices, an initial prediction of an amount of time to complete the generation of the floor plan for the building that is determined based at least in part on the determined computing resources and on information about past performance of the user in acquiring images and on publicly available information about the building,
   and wherein the generating of the predicted amount of time to complete the generation of the floor plan for the building and the generating of the revised predicted amount of time for each of the multiple iterations is further based in part on the determined computing resources.
A08. The computer-implemented method of clause A07 wherein the one or more computing devices include an image acquisition computing device with one or more cameras that is used to acquire the one or more first images and the additional images, wherein the analyzing of the visual data of the one or more first images is performed by the image acquisition computing device and includes determining, for each of one or more first rooms that include the first acquisition locations, an initial estimated room shape of that first room, and wherein the providing of the feedback to the one or more users is performed by the image acquisition computing device and includes displaying information on the image acquisition computing device that includes the predicted amount of time and the initial estimated room shape for each of the one or more first rooms and one or more indications of aspects of the one or more first images to change during acquisition of the additional images to produce the improvement in the additional images.
A09. The computer-implemented method of clause A08 wherein the one or more computing devices further include one or more additional computing devices, and wherein the method further comprises:
   transmitting, by the image acquisition computing device, data over one or more networks to the one or more additional computing devices that includes information from the one or more first images and the additional images;
   generating, by the one or more additional computing devices and as part of the automated generation process, the floor plan for the building using the transmitted data, including determining final room shapes for the multiple rooms, and combining the final room shapes for the multiple rooms to complete the floor plan; and
   providing, by the one or more additional computing devices, the floor plan for the building for further use.
A10. The computer-implemented method of clause A08 wherein the providing of the feedback to the one or more users by the image acquisition computing device further includes displaying instructions to correct one of the first images based at least in part on at least one assessed attribute of the one first image that reflects quality of the visual data of the one first image.
A11. The computer-implemented method of clause A10 further comprising, before the obtaining of the one or more second images:
   acquiring, by the image acquisition computing device after the providing of the feedback, a new image to replace the one first image that includes one or more improvements to correct the one first image;
   predicting, by the one or more computing devices and based at least in part on one or more assessed attributes of the one first image, an adjusted predicted amount of time to complete the floor plan for the building that is less than the predicted amount of time based at least in part on the one or more improvements; and
   displaying, by the image acquisition computing device, the adjusted predicted amount of time.
A12. The computer-implemented method of any one of clauses A01-A11 wherein the mapping information for the building includes a floor plan for the building, and wherein the automated operations further include producing and providing the floor plan for the building.
A13. The computer-implemented method of clause A12 wherein the providing of the feedback includes providing the feedback to one or more users associated with acquiring of the one or more first images and acquiring of the additional images and includes providing information about the assessed one or more attributes of the one or more first images, wherein the assessed one or more attributes of the one or more first images include at least one assessment of quality of the visual data of the one or more first images, and wherein the using of the at least revised predicted amount of time includes providing revised feedback to the one or more users that includes the revised predicted amount of time, to enable further improvement in producing the floor plan.
A14. The computer-implemented method of clause A13 wherein the providing of the feedback and the revised feedback to the one or more users includes displaying the feedback and the revised feedback in a graphical user interface, and wherein the providing of the floor plan for the building is performed after the floor plan is completed and includes displaying the completed floor plan in the graphical user interface.
A15. The computer-implemented method of any one of clauses A01-A14 wherein the one or more computing devices include an image acquisition computing device with one or more cameras that is used to acquire the one or more first images and the additional images, wherein the analyzing of the visual data of the one or more first images is performed at least in part by the image acquisition computing device and includes determining, for each of the one or more first rooms, an initial estimated room shape of that first room, and wherein the providing of the feedback is performed by the image acquisition computing device and includes displaying information on the image acquisition computing device to one or more users that includes the predicted amount of time and the initial estimated room shape for each of the one or more first rooms and one or more indications of aspects of the one or more first images to change during acquisition of the additional images to produce the improvement in the generation process.
A16. The computer-implemented method of clause A15 wherein the mapping information includes a floor plan for the building, wherein the one or more computing devices further include one or more additional computing devices, and wherein the automated operations further include:
   transmitting, by the image acquisition computing device, data over one or more networks to the one or more additional computing devices that includes information from the one or more first images and the additional images;
   generating, by the one or more additional computing devices and as part of the generation process, the floor plan for the building using the transmitted data, including determining final room shapes for the multiple rooms, and combining the final room shapes for the multiple rooms to complete the floor plan; and
   providing, by the one or more additional computing devices, the floor plan for the building for further use.
A17. The computer-implemented method of clause A16 wherein the generating of the floor plan for the building further includes obtaining input from one or more users related to at least one of the final room shapes for the multiple rooms or the combining of the final room shapes, and using the obtained input as part of the generating of the floor plan.
A18. The computer-implemented method of clause A15 wherein the providing of the feedback by the image acquisition computing device further includes initiating one or more corrections to one of the first images, and wherein the automated operations further include:
   acquiring, by the image acquisition computing device after the providing of the feedback, a new image to replace the one first image that includes one or more improvements to correct the one first image;
   predicting, based at least in part on one or more assessed attributes of the one first image, an adjusted predicted amount of time for the producing of the mapping information that is less than the predicted amount of time based at least in part on the one or more improvements; and
   providing, by the image acquisition computing device, the adjusted predicted amount of time.
A19. The computer-implemented method of clause A15 wherein the first and additional images are each a panorama image having 360 degrees of horizontal visual coverage around a vertical axis, wherein acquiring of the first and additional images is performed without using any depth information from any depth-sensing sensors for distances to surrounding surfaces and includes using one or more inertial measurement unit (IMU) sensors of the image acquisition computing device to acquire motion data, and wherein the automated operations further include:
   determining, for each of the first and additional images, acquisition pose information based at least in part on the motion data acquired by the one or more IMU sensors during acquiring of that image and on visual data of that image,
   and wherein the determining of the initial estimated room shape for each of the one or more first images is based in part on the respective determined acquisition pose information for each of the one or more first images.
A20. The computer-implemented method of any one of clauses A01-A19 wherein the mapping information includes at least one of a three-dimensional model of an interior of the building or a virtual tour involving user-selectable inter-connections between at least some of the first and additional images that represent at least inter-image directions, and wherein the automated operations further include presenting the mapping information to enable interactions with the presented mapping information by one or more users.
A21. The computer-implemented method of any one of clauses A01-A20 wherein the analyzing of the visual data of the one or more first images includes identifying one or more problems to correct that include at least one of a lack of inter-image line-of-sight between visual data of at least one of the first images and at least one other acquired image, or a lack of overlap between visual data of at least one of the first images and at least one other acquired image, or a quantity of acquired images that is below a defined minimum threshold, or a quantity of acquired images that is above a defined maximum threshold, or a distance between an acquisition location of one of the first images and at least one wall, or a lack of line-of-sight through at least one doorway for at least one of the first images, or visibility of at least a portion of equipment used in acquiring at least one of the first images, or changes to the equipment used in acquiring at least one of the first images relative to acquiring one or more other images, or visibility of at least a portion of a user involved in acquiring at least one of the first images, or visibility of obstructions in visual data of at least one of the first images that block visibility of one or more walls, or a lack of coverage of all of the multiple rooms, or a lack of coverage of all of at least one of the multiple rooms, or uncertainty in determination of a room shape of at least one of the multiple rooms based on visual data of at least one of the first images, or an inability to detect one or more windows or doorways or non-doorway wall openings in visual data of at least one of the first images, and wherein the providing of the feedback further includes providing information to correct the identified one or more problems.
A22. The computer-implemented method of any one of clauses A01-A21 wherein generating of predicted and revised predicted amounts of time includes using information about attributes of images acquired for the producing of the mapping information for the building in combination with additional information about at least one of a size of the building, or a style of the building, or a number of stories of the building, or a number of levels of the building, or a number of rooms of the building, or a number of rooms of an indicated type of the building, or a type of one or more rooms of the building, or a type of one or more walls of the building, or whether the building is furnished, or data available from one or more sensors of one or more types on one or more image acquisition devices used for acquiring the images for the producing of the mapping information for the building, or a quantity of the images acquired for the producing of the mapping information for the building, or an assessed quality of the images acquired for the producing of the mapping information for the building, or an amount of coverage of all of the multiple rooms by visual data of the images acquired for the producing of the mapping information for the building, or uncertainty in determination of room shapes of the multiple rooms based on visual data of the images acquired for the producing of the mapping information for the building, or detection of at least one of windows or doorways or non-doorway wall openings in visual data of the images acquired for the producing of the mapping information for the building, or an amount of computing resources available for the producing of the mapping information for the building, or availability of one or more users to assist in the producing of the mapping information, or information about at least one user involved in acquiring the images for the producing of the mapping information for the building, or about one or more other buildings having similarities to the building.
A23. The computer-implemented method of any one of clauses A01-A22 wherein acquiring of the first and additional images for the building is performed by one or more users, wherein the using of the at least revised predicted amount of time includes providing further feedback that includes at least the revised predicted amount of time, and wherein the automated operations further include, before acquiring any images of the building for use in the producing of the mapping information for the building:
   determining computing resources available for implementing the generation process;
   determining an initial prediction of an amount of time for the producing of the mapping information for the building that is based at least in part on the determined computing resources and on information about the one or more users and on publicly available information about the building; and
   presenting to the one or more users the determined initial prediction of the amount of time,
   and wherein the providing of the feedback and of the revised feedback is performed to provide repeated updates to the one or more users of a predicted amount of time based on cumulative acquisition of images for the building.
A24. The computer-implemented method of any one of clauses A01-A23 wherein the using of the at least revised predicted amount of time includes providing further feedback that includes at least the revised predicted amount of time, and wherein the automated operations further include:
   determining, based at least in part on the one or more first images and before acquiring of the one or more second images, a current status of acquiring images for the generation process that includes one or more characteristics of at least one of an amount completed of the acquiring of the images for the generation process or an amount remaining of the acquiring of the images for the generation process, and wherein the providing of the feedback includes providing information to one or more users that includes the predicted amount of time and the determined current status including the one or more characteristics; and
   determining, based at least in part on the one or more second images, a revised current status of acquiring images for the generation process that includes revisions to the one or more characteristics, and wherein the providing of the further feedback includes providing information to the one or more users that includes the revised predicted amount of time and the determined revised current status.
A25. The computer-implemented method of any one of clauses A01-A24 wherein the one or more computing devices include an image acquisition computing device with one or more cameras that is used to acquire the one or more first images and the additional images, wherein the providing of the feedback and the revised feedback is performed by the image acquisition computing device and includes displaying the feedback and the revised feedback in a graphical user interface, and wherein the automated operations further include displaying the floor plan in the graphical user interface.
A26. The computer-implemented method of any one of clauses A01-A25 wherein the predicted amount of resources involved with the producing of the floor plan for the building includes at least one of an amount of time until completion of the producing of the floor plan, or an amount of computing resources used in the producing of the floor plan, or an amount with respect to one or more indicated cost metrics.
A27. The computer-implemented method of any one of clauses A01-A26 wherein the one or more computing devices include an image acquisition computing device with one or more cameras that is used to acquire the one or more first images and the additional images, wherein the analyzing of the visual data of the one or more first images is performed by the image acquisition computing device and includes determining, for each of the one or more first rooms, an initial estimated room shape of that first room, and wherein the providing of the feedback to the one or more users is performed by the image acquisition computing device and includes displaying information on the image acquisition computing device that includes the predicted amount of the one or more resources and the initial estimated room shape for each of the one or more first rooms and one or more indications of aspects of the one or more first images to change during acquisition of the additional images to produce the improvement in the automated generation process.
A28. The computer-implemented method of clause A27 wherein the one or more computing devices further include one or more additional computing devices, and wherein the automated operations further include:
   transmitting, by the image acquisition computing device, data over one or more networks to the one or more additional computing devices that includes information from the one or more first images and the additional images;
   generating, by the one or more additional computing devices and as part of the automated generation process, the floor plan for the building using the transmitted data, including determining final room shapes for the multiple rooms, and combining the final room shapes for the multiple rooms to complete the floor plan; and
   providing, by the one or more additional computing devices, the floor plan for the building for further use.
A29. The computer-implemented method of clause A27 wherein the providing of the feedback to the one or more users by the image acquisition computing device further includes displaying instructions to correct one of the first images based at least in part on at least one assessed attribute of the one first image that reflects quality of the visual data of the one first image.
A30. The computer-implemented method of clause A29 wherein the automated operations further include:
   acquiring, by the image acquisition computing device after the providing of the feedback, a new image to replace the one first image that includes one or more improvements to correct the one first image;
   predicting, by the one or more computing devices and based at least in part on one or more assessed attributes of the one first image, an adjusted predicted amount of resources involved with the producing of the floor plan for the building that is less than the predicted amount of resources based at least in part on the one or more improvements; and
   displaying, by the image acquisition computing device, the adjusted predicted amount of resources involved with the producing of the floor plan for the building.
A31. The computer-implemented method of any one of clauses A01-A30 wherein the predicted one or more characteristics of the automated generation process for producing the floor plan for the building include a predicted amount of time to complete acquisition of images in all of the multiple rooms, and wherein the providing of the feedback to the one or more users further includes the predicted amount of time to complete the acquisition of the images in all of the multiple rooms.
A32. The computer-implemented method of any one of clauses A01-A31 wherein the one or more computing devices include an image acquisition computing device with one or more cameras.
A33. A computer-implemented method comprising multiple steps to perform automated operations that implement described techniques substantially as disclosed herein.
B01. A non-transitory computer-readable medium having stored executable software instructions and/or other stored contents that cause one or more computing systems to perform automated operations that implement the method of any of clauses A01-A33.
B02. A non-transitory computer-readable medium having stored executable software instructions and/or other stored contents that cause one or more computing systems to perform automated operations that implement described techniques substantially as disclosed herein.
C01. One or more computing systems comprising one or more hardware processors and one or more memories with stored instructions that, when executed by at least one of the one or more hardware processors, cause the one or more computing systems to perform automated operations that implement the method of any of clauses A01-A33.
C02. One or more computing systems comprising one or more hardware processors and one or more memories with stored instructions that, when executed by at least one of the one or more hardware processors, cause the one or more computing systems to perform automated operations that implement described techniques substantially as disclosed herein.
D01. A computer program adapted to perform the method of any of clauses A01-A33 when the computer program is run on a computer.

Aspects of the present disclosure are described herein with reference to flowchart illustrations and/or block diagrams of methods, apparatus (systems), and computer program products according to embodiments of the present disclosure. It will be appreciated that each block of the flowchart illustrations and/or block diagrams, and combinations of blocks in the flowchart illustrations and/or block diagrams, can be implemented by computer readable program instructions. It will be further appreciated that in some implementations the functionality provided by the routines discussed above may be provided in alternative ways, such as being split among more routines or consolidated into fewer routines. Similarly, in some implementations illustrated routines may provide more or less functionality than is described, such as when other illustrated routines instead lack or include such functionality respectively, or when the amount of functionality that is provided is altered. In addition, while various operations may be illustrated as being performed in a particular manner (e.g., in serial or in parallel, or synchronous or asynchronous) and/or in a particular order, in other implementations the operations may be performed in other orders and in other manners. Any data structures discussed above may also be structured in different manners, such as by having a single data structure split into multiple data structures and/or by having multiple data structures consolidated into a single data structure. Similarly, in some implementations illustrated data structures may store more or less information than is described, such as when other illustrated data structures instead lack or include such information respectively, or when the amount or types of information that is stored is altered.

From the foregoing it will be appreciated that, although specific embodiments have been described herein for purposes of illustration, various modifications may be made without deviating from the spirit and scope of the invention. Accordingly, the invention is not limited except as by corresponding claims and the elements recited by those claims. In addition, while certain aspects of the invention may be presented in certain claim forms at certain times, the inventors contemplate the various aspects of the invention in any available claim form. For example, while only some aspects of the invention may be recited as being embodied in a computer-readable medium at particular times, other aspects may likewise be so embodied.

## Claims

1. A system comprising:
one or more hardware processors of one or more computing devices; and
one or more memories with stored instructions that, when executed by at least one of the one or more hardware processors, cause at least one of the one or more computing devices to perform automated operations including at least:
obtaining, for a building with multiple rooms, one or more first images acquired at one or more first acquisition locations in one or more first rooms of the multiple rooms, wherein each of the first images has visual coverage of at least some walls of one of the first rooms that includes the respective first acquisition location for that first image;
analyzing visual data of the one or more first images to assess one or more attributes of the one or more first images;
generating, based at least in part on the assessed one or more attributes of the one or more first images, one or more predicted characteristics of a generation process for producing mapping information for the building that include a predicted amount of time for the producing of the mapping information, wherein the generation process is based at least in part on analysis of the visual data of the one or more first images and on future analysis of additional images to be acquired at additional acquisition locations for the building;
providing feedback that includes at least the predicted amount of time, to enable improvement in the generation process resulting at least in part from the additional images to be acquired;
obtaining one or more second images of the additional images that are acquired at one or more additional second acquisition locations for the building;
analyzing visual data of the one or more second images to assess at least one attribute of the one or more second images;
generating, based at least in part on the assessed at least one attribute of the one or more second images, one or more updated predicted characteristics of the generation process that include a revised predicted amount of time for the producing of the mapping information for the building; and
using at least the revised predicted amount of time to enable further improvement in the generation process.

2. The system of claim 1 wherein the mapping information for the building includes a floor plan for the building, wherein the automated operations further include producing the floor plan for the building, wherein the providing of the feedback includes providing the feedback to one or more users associated with acquiring of the one or more first images and acquiring of the additional images and includes providing information about the assessed one or more attributes of the one or more first images, wherein the assessed one or more attributes of the one or more first images include at least one assessment of quality of the visual data of the one or more first images, wherein the using of the at least revised predicted amount of time includes providing revised feedback to the one or more users that includes the revised predicted amount of time, to enable further improvement in producing the floor plan, wherein the providing of the feedback and the revised feedback to the one or more users includes displaying the feedback and the revised feedback in a graphical user interface, and wherein the providing of the floor plan for the building is performed after the floor plan is completed and includes displaying the completed floor plan in the graphical user interface.

3. The system of claim 1 wherein the one or more computing devices include an image acquisition computing device with one or more cameras that is used to acquire the one or more first images and the additional images, wherein the analyzing of the visual data of the one or more first images is performed at least in part by the image acquisition computing device and includes determining, for each of the one or more first rooms, an initial estimated room shape of that first room, and wherein the providing of the feedback is performed by the image acquisition computing device and includes displaying information on the image acquisition computing device to one or more users that includes the predicted amount of time and the initial estimated room shape for each of the one or more first rooms and one or more indications of aspects of the one or more first images to change during acquisition of the additional images to produce the improvement in the generation process.

4. The system of claim 3 wherein the mapping information includes a floor plan for the building, wherein the one or more computing devices further include one or more additional computing devices, and wherein the automated operations further include:
transmitting, by the image acquisition computing device, data over one or more networks to the one or more additional computing devices that includes information from the one or more first images and the additional images;
generating, by the one or more additional computing devices and as part of the generation process, the floor plan for the building using the transmitted data, including determining final room shapes for the multiple rooms, and combining the final room shapes for the multiple rooms to complete the floor plan; and
providing, by the one or more additional computing devices, the floor plan for the building for further use.

5. The system of claim 4 wherein the generating of the floor plan for the building further includes obtaining input from one or more users related to at least one of the final room shapes for the multiple rooms or the combining of the final room shapes, and using the obtained input as part of the generating of the floor plan.

6. The system of claim 3 wherein the providing of the feedback by the image acquisition computing device further includes initiating one or more corrections to one of the first images, and wherein the automated operations further include:
acquiring, by the image acquisition computing device after the providing of the feedback, a new image to replace the one first image that includes one or more improvements to correct the one first image;
predicting, based at least in part on one or more assessed attributes of the one first image, an adjusted predicted amount of time for the producing of the mapping information that is less than the predicted amount of time based at least in part on the one or more improvements; and
providing, by the image acquisition computing device, the adjusted predicted amount of time.

7. The system of claim 3 wherein the first and additional images are each a panorama image having 360 degrees of horizontal visual coverage around a vertical axis, wherein acquiring of the first and additional images is performed without using any depth information from any depth-sensing sensors for distances to surrounding surfaces and includes using one or more inertial measurement unit (IMU) sensors of the image acquisition computing device to acquire motion data, and wherein the stored instructions include software instructions that, when executed by the one or more hardware processors, cause the image acquisition computing device to perform further automated operations including:
determining, for each of the first and additional images, acquisition pose information based at least in part on the motion data acquired by the one or more IMU sensors during acquiring of that image and on visual data of that image,
and wherein the determining of the initial estimated room shape for each of the one or more first images is based in part on the respective determined acquisition pose information for each of the one or more first images.

8. The system of claim 1 wherein the mapping information includes at least one of a three-dimensional model of an interior of the building or a virtual tour involving user-selectable inter-connections between at least some of the first and additional images that represent at least inter-image directions, and wherein the automated operations further include presenting the mapping information to enable interactions with the presented mapping information by one or more users.

9. The system of claim 1 wherein the analyzing of the visual data of the one or more first images includes identifying one or more problems to correct that include at least one of a lack of inter-image line-of-sight between visual data of at least one of the first images and at least one other acquired image, or a lack of overlap between visual data of at least one of the first images and at least one other acquired image, or a quantity of acquired images that is below a defined minimum threshold, or a quantity of acquired images that is above a defined maximum threshold, or a distance between an acquisition location of one of the first images and at least one wall, or a lack of line-of-sight through at least one doorway for at least one of the first images, or visibility of at least a portion of equipment used in acquiring at least one of the first images, or changes to the equipment used in acquiring at least one of the first images relative to acquiring one or more other images, or visibility of at least a portion of a user involved in acquiring at least one of the first images, or visibility of obstructions in visual data of at least one of the first images that block visibility of one or more walls, or a lack of coverage of all of the multiple rooms, or a lack of coverage of all of at least one of the multiple rooms, or uncertainty in determination of a room shape of at least one of the multiple rooms based on visual data of at least one of the first images, or an inability to detect one or more windows or doorways or non-doorway wall openings in visual data of at least one of the first images, and wherein the providing of the feedback further includes providing information to correct the identified one or more problems.

10. The system of claim 1 wherein generating of predicted and revised predicted amounts of time includes using information about attributes of images acquired for the producing of the mapping information for the building in combination with additional information about at least one of a size of the building, or a style of the building, or a number of stories of the building, or a number of levels of the building, or a number of rooms of the building, or a number of rooms of an indicated type of the building, or a type of one or more rooms of the building, or a type of one or more walls of the building, or whether the building is furnished, or data available from one or more sensors of one or more types on one or more image acquisition devices used for acquiring the images for the producing of the mapping information for the building, or a quantity of the images acquired for the producing of the mapping information for the building, or an assessed quality of the images acquired for the producing of the mapping information for the building, or an amount of coverage of all of the multiple rooms by visual data of the images acquired for the producing of the mapping information for the building, or uncertainty in determination of room shapes of the multiple rooms based on visual data of the images acquired for the producing of the mapping information for the building, or detection of at least one of windows or doorways or non-doorway wall openings in visual data of the images acquired for the producing of the mapping information for the building, or an amount of computing resources available for the producing of the mapping information for the building, or availability of one or more users to assist in the producing of the mapping information, or information about at least one user involved in acquiring the images for the producing of the mapping information for the building, or about one or more other buildings having similarities to the building.

11. The system of claim 1 wherein acquiring of the first and additional images for the building is performed by one or more users, wherein the using of the at least revised predicted amount of time includes providing further feedback that includes at least the revised predicted amount of time, and wherein the automated operations further include, before acquiring any images of the building for use in the producing of the mapping information for the building:
determining computing resources available for implementing the generation process;
determining an initial prediction of an amount of time for the producing of the mapping information for the building that is based at least in part on the determined computing resources and on information about the one or more users and on publicly available information about the building; and
presenting to the one or more users the determined initial prediction of the amount of time,
and wherein the providing of the feedback and of the revised feedback is performed to provide repeated updates to the one or more users of a predicted amount of time based on cumulative acquisition of images for the building.

12. The system of claim 1 wherein the using of the at least revised predicted amount of time includes providing further feedback that includes at least the revised predicted amount of time, and wherein the automated operations further include:
determining, based at least in part on the one or more first images and before acquiring of the one or more second images, a current status of acquiring images for the generation process that includes one or more characteristics of at least one of an amount completed of the acquiring of the images for the generation process or an amount remaining of the acquiring of the images for the generation process, and wherein the providing of the feedback includes providing information to one or more users that includes the predicted amount of time and the determined current status including the one or more characteristics; and
determining, based at least in part on the one or more second images, a revised current status of acquiring images for the generation process that includes revisions to the one or more characteristics, and wherein the providing of the further feedback includes providing information to the one or more users that includes the revised predicted amount of time and the determined revised current status.

13. A computer-implemented method comprising:
obtaining, by one or more computing devices and for a building with multiple rooms, one or more first images acquired by one or more users at one or more first acquisition locations in a subset of the multiple rooms, wherein each of the first images has visual coverage of at least some walls of one of the multiple rooms in which the respective first acquisition location for that first image is located;
analyzing, by the one or more computing devices, visual data of the one or more first images to assess one or more attributes of the one or more first images;
predicting, by the one or more computing devices and based at least in part on the assessed one or more attributes of the one or more first images, one or more characteristics of an automated generation process to produce a floor plan for the building, wherein the automated generation process is based on analysis of the visual data of the one or more first images and is based on future analysis of additional images to be acquired at additional acquisition locations for the building, and wherein the predicted one or more characteristics include a predicted amount of time to complete the floor plan for the building;
presenting, by the one or more computing devices, feedback to the one or more users that includes at least the predicted amount of time, to enable improvement in the additional images to be acquired;
obtaining, by the one or more computing devices, one or more second images of the additional images that are acquired by the one or more users at one or more additional second acquisition locations for the building;
analyzing, by the one or more computing devices, visual data of the one or more second images to assess at least one attribute of the one or more second images;
predicting, by the one or more computing devices and based at least in part on the assessed at least one attribute of the one or more second images, one or more updated characteristics of the automated generation process that include a revised predicted amount of time to complete the floor plan for the building; and
presenting, by the one or more computing devices, revised feedback to the one or more users that includes at least the revised predicted amount of time, to enable further improvement in the automated generation process.

14. A non-transitory computer-readable medium having stored contents that cause one or more computing devices to perform automated operations including at least:
obtaining, by the one or more computing devices and for a building with multiple rooms, one or more first images acquired by one or more users at one or more first acquisition locations in one or more first rooms, wherein each of the first images has visual coverage of at least some walls of one of the first rooms that includes the respective first acquisition location for that first image;
analyzing, by the one or more computing devices, visual data of the one or more first images to assess one or more attributes of the one or more first images;
predicting, by the one or more computing devices and based at least in part on the assessed one or more attributes of the one or more first images, one or more characteristics of an automated generation process for producing a floor plan for the building, wherein the automated generation process is based on analysis of the visual data of the one or more first images and is based on future analysis of additional images to be acquired at additional acquisition locations for the building, and wherein the predicted one or more characteristics include a predicted amount of one or more resources involved with the producing of the floor plan for the building;
providing, by the one or more computing devices, feedback to the one or more users that includes at least the predicted amount of the one or more resources, to enable improvement in the automated generation process resulting at least in part from acquiring of the additional images;
obtaining, by the one or more computing devices, one or more second images of the additional images that are acquired by the one or more users at one or more additional second acquisition locations for the building;
analyzing, by the one or more computing devices, visual data of the one or more second images to assess at least one attribute of the one or more second images;
predicting, by the one or more computing devices and based at least in part on the assessed at least one attribute of the one or more second images, one or more updated characteristics of the automated generation process that include a revised predicted amount of the one or more resources involved with the producing of the floor plan for the building; and
providing, by the one or more computing devices, revised feedback to the one or more users that includes at least the revised predicted amount of the one or more resources, to enable further improvement in the automated generation process.

15. The non-transitory computer-readable medium of claim 14 wherein the one or more computing devices include an image acquisition computing device with one or more cameras that is used to acquire the one or more first images and the additional images, wherein the predicted amount of resources involved with the producing of the floor plan for the building includes at least one of an amount of time until completion of the producing of the floor plan, or an amount of computing resources used in the producing of the floor plan, or an amount with respect to one or more indicated cost metrics, wherein the providing of the feedback and the revised feedback is performed by the image acquisition computing device and includes displaying the feedback and the revised feedback in a graphical user interface, and wherein the stored contents include software instructions that, when executed by the image acquisition computing device, further include displaying the floor plan in the graphical user interface.
